# EUROPEAN PATENT APPLICATION

(11) **EP 4 481 825 A1**
(43) Date of publication of application: **25.12.2024**
(21) Application number: 23752773.4
(22) Date of filing: 02.02.2023
(51) Int. Cl.: H01L 27/146, H01L 31/02, H04N 25/70, H10K 30/60

(54) **PHOTOELECTRIC CONVERSION ELEMENT AND OPTICAL DETECTION DEVICE**

(30) Priority: 14.02.2022 JP 2022020877
(71) Applicant: Sony Semiconductor Solutions Corporation, Atsugi-shi, Kanagawa 243-0014 (JP)
(72) Inventor: TAKAGUCHI, Ryotaro, Atsugi-shi, Kanagawa 243-0014 (JP); JOEI, Masahiro, Atsugi-shi, Kanagawa 243-0014 (JP); SUZUKI, Ryosuke, Atsugi-shi, Kanagawa 243-0014 (JP); YAGI, Iwao, Atsugi-shi, Kanagawa 243-0014 (JP); HIRATA, Shintarou, Atsugi-shi, Kanagawa 243-0014 (JP)
(74) Representative: Müller Hoffmann & Partner
(86) International application number: PCT/JP2023/003411
(87) International publication number: WO 2023/153308

(57) **Abstract**

A first photoelectric conversion element according to one embodiment of the present disclosure includes: a first electrode and a second electrode that are disposed side by side; a third electrode disposed to oppose the first electrode and the second electrode; a photoelectric conversion layer provided between the first electrode and the second electrode and the third electrode; an oxide semiconductor layer provided between the first electrode and the second electrode and the photoelectric conversion layer; and a protective layer provided between the photoelectric conversion layer and the oxide semiconductor layer. The protective layer includes a first layer and a second layer that include oxygen (O), an element X, and an element Y as a common element. The first layer and the second layer are stacked in this order from a side of the oxide semiconductor layer. The first layer and the second layer satisfy Rₓ₁ > Rₓ₂ ≥ 0 and 0 ≤ R_{y1} < R_{y2} in a case where a composition ratio of the element X and the element Y is defined as number of atoms of each of the element X and the element Y divided by total number of atoms of the element X and the element Y, and where the composition ratio of the element X included in the first layer is referred to as Rₓ₁, the composition ratio of the element Y included in the first layer is referred to as R_{y1}, the composition ratio of the element X included in the second layer is referred to as Rₓ₂, and the composition ratio of the element Y included in the second layer is referred to as R_{y2}.

## Description

### Technical Field

The present disclosure relates to a photoelectric conversion element including, for example, an organic material, and a photodetector including the photoelectric conversion element.

### Background Art

For example, PTL 1 discloses an imaging element that includes a photoelectric converter in which a first electrode, a photoelectric conversion layer, and a second electrode are stacked. In the photoelectric converter, an oxide film and an oxide semiconductor layer are formed between the first electrode and the photoelectric conversion layer from a side of the photoelectric conversion layer.

### Citation List

### Patent Literature

PTL 1: International Publication No. WO2020/017330

### Summary of Invention

Incidentally, it is desired that imaging quality of photodetectors be improved.

It is desirable to provide a photoelectric conversion element and a photodetector that make it possible to improve imaging quality.

A first photoelectric conversion element according to an embodiment of the present disclosure includes a first electrode, a second electrode, a third electrode, a photoelectric conversion layer, an oxide semiconductor layer, and a protective layer. The first electrode and the second electrode are disposed side by side. The third electrode is disposed to oppose the first electrode and the second electrode. The photoelectric conversion layer is provided between the first electrode and the second electrode and the third electrode. The oxide semiconductor layer is provided between the first electrode and the second electrode and the photoelectric conversion layer. The protective layer is provided between the photoelectric conversion layer and the oxide semiconductor layer. The protective layer includes a first layer and a second layer. The first layer and the second layer include oxygen (O), an element X, and an element Y as a common element. The first layer and the second layer are stacked in this order from a side of the oxide semiconductor layer. The first layer and the second layer satisfy Rₓ₁ > Rₓ₂ ≥ 0 and 0 ≤ R_{y1} < R_{y2} in a case where a composition ratio of the element X and the element Y is defined as number of atoms of each of the element X and the element Y divided by total number of atoms of the element X and the element Y, and where the composition ratio of the element X included in the first layer is referred to as Rₓ₁, the composition ratio of the element Y included in the first layer is referred to as R_{y1}, the composition ratio of the element X included in the second layer is referred to as Rₓ₂, and the composition ratio of the element Y included in the second layer is referred to as R_{y2}.

A second photoelectric conversion element according to an embodiment of the present disclosure includes a first electrode, a second electrode, a third electrode, a photoelectric conversion layer, an oxide semiconductor layer, and a protective layer. The first electrode and the second electrode are disposed side by side. The third electrode is disposed to oppose the first electrode and the second electrode. The photoelectric conversion layer is provided between the first electrode and the second electrode and the third electrode. The oxide semiconductor layer is provided between the first electrode and the second electrode and the photoelectric conversion layer. The protective layer is provided between the photoelectric conversion layer and the oxide semiconductor layer. The protective layer includes a plurality of layers. At least one of the plurality of layers has an opening at a position opposed to the first electrode.

A photodetector according to an embodiment of the present disclosure includes one or more first photoelectric conversion elements according to an embodiment of the present disclosure for each of a plurality of pixels.

A first photoelectric conversion element according to an embodiment of the present disclosure and a photodetector according to an embodiment of the present disclosure include a protective layer provided between the photoelectric conversion layer and the oxide semiconductor layer. The protective layer includes a first layer and a second layer. The first layer and the second layer include oxygen (O), an element X, and an element Y as a common element. The first layer and the second layer are stacked in this order from a side of the oxide semiconductor layer. The first layer and the second layer satisfy Rₓ₁ > Rₓ₂ ≥ 0 and 0 ≤ R_{y1} < R_{y2} in a case where a composition ratio of the element X and the element Y is defined as number of atoms of each of the element X and the element Y divided by total number of atoms of the element X and the element Y, and where the composition ratio of the element X included in the first layer is referred to as Rₓ₁, the composition ratio of the element Y included in the first layer is referred to as R_{y1}, the composition ratio of the element X included in the second layer is referred to as Rₓ₂, and the composition ratio of the element Y included in the second layer is referred to as R_{y2}. A second photoelectric conversion element according to an embodiment of the present disclosure includes a protective layer provided between the oxide semiconductor layer and the photoelectric conversion layer. The protective layer includes a plurality of layers. At least one of the plurality of layers has an opening at a position opposed to the first electrode. This reduces defects in the oxide semiconductor layer without hindering transport of carriers from the photoelectric conversion layer.

### Brief Description of Drawings

[FIG. 1] FIG. 1 is a schematic cross-sectional diagram illustrating an example of a configuration of an imaging element according to a first embodiment of the present disclosure.
[FIG. 2] FIG. 2 is a schematic diagram illustrating an example of a planar configuration of an imaging device including the imaging element illustrated in FIG. 1.
[FIG. 3] FIG. 3 is a schematic plan diagram illustrating an example of a pixel configuration of the imaging device including the imaging element illustrated in FIG. 1.
[FIG. 4] FIG. 4 is a schematic cross-sectional diagram illustrating an example of a configuration of a photoelectric converter illustrated in FIG. 1.
[FIG. 5A] FIG. 5A is a diagram illustrating an example of an energy level of each layer on an accumulation electrode of the photoelectric converter illustrated in FIG. 4.
[FIG. 5B] FIG. 5B is a diagram illustrating another example of an energy level of each layer on the accumulation electrode of the photoelectric converter illustrated in FIG. 4.
[FIG. 6] FIG. 6 is an equivalent circuit diagram of the imaging element illustrated in FIG. 1.
[FIG. 7] FIG. 7 is a schematic diagram illustrating an arrangement of transistors constituting a lower electrode and a control unit of the imaging element illustrated in FIG. 1.
[FIG. 8] FIG. 8 is a cross-sectional diagram for describing a method of manufacturing the imaging element illustrated in FIG. 1.
[FIG. 9] FIG. 9 is a cross-sectional diagram illustrating a step subsequent to FIG. 8.
[FIG. 10] FIG. 10 is a cross-sectional diagram illustrating a step subsequent to FIG. 9.
[FIG. 11] FIG. 11 is a cross-sectional diagram illustrating a step subsequent to FIG. 10.
[FIG. 12] FIG. 12 is a cross-sectional diagram illustrating a step subsequent to FIG. 11.
[FIG. 13] FIG. 13 is a cross-sectional diagram illustrating a step subsequent to FIG. 12.
[FIG. 14] FIG. 14 is a timing diagram illustrating an operation example of the imaging element illustrated in FIG. 1.
[FIG. 15] FIG. 15 is a schematic cross-sectional diagram illustrating an example of a configuration of a photoelectric converter according to a second embodiment of the present disclosure.
[FIG. 16A] FIG. 16A is a diagram illustrating an energy level of each layer on a readout electrode of the photoelectric converter illustrated in FIG. 15.
[FIG. 16B] FIG. 16B is a diagram illustrating an energy level of each layer on an accumulation electrode of the photoelectric converter illustrated in FIG. 15.
[FIG. 17] FIG. 17 is a schematic cross-sectional diagram illustrating another example of a configuration of the photoelectric converter according to the second embodiment of the present disclosure.
[FIG. 18] FIG. 18 is a schematic plan diagram illustrating an example of a pixel configuration of an imaging device including an imaging element illustrated in FIG. 17.
[FIG. 19] FIG. 19 is a schematic cross-sectional diagram illustrating a configuration of a photoelectric converter according to Modification Example 1 of the present disclosure.
[FIG. 20A] FIG. 20A is a diagram illustrating an energy level of each layer on a readout electrode of the photoelectric converter illustrated in FIG. 19.
[FIG. 20B] FIG. 20B is a diagram illustrating an energy level of each layer on an accumulation electrode of the photoelectric converter illustrated in FIG. 19.
[FIG. 21] FIG. 21 is a schematic cross-sectional diagram illustrating a configuration of a photoelectric converter according to Modification Example 2 of the present disclosure.
[FIG. 22] FIG. 22 is a schematic plan diagram illustrating an example of a pixel configuration of an imaging device including an imaging element illustrated in FIG. 21.
[FIG. 23] FIG. 23 is a schematic cross-sectional diagram illustrating a configuration of a photoelectric converter according to Modification Example 3 of the present disclosure.
[FIG. 24] FIG. 24 is a schematic plan diagram illustrating an example of a pixel configuration of an imaging device including an imaging element illustrated in FIG. 23.
[FIG. 25A] FIG. 25A is a schematic cross-sectional diagram illustrating an example of a configuration of an imaging element according to Modification Example 4 of the present disclosure.
[FIG. 25B] FIG. 25B is a schematic plan diagram illustrating an example of a pixel configuration of an imaging device including the imaging element illustrated in FIG. 25A.
[FIG. 26A] FIG. 26A is a schematic cross-sectional diagram illustrating an example of a configuration of an imaging element according to Modification Example 5 of the present disclosure.
[FIG. 26B] FIG. 26B is a schematic plan diagram illustrating an example of a pixel configuration of an imaging device including the imaging element illustrated in FIG. 26A.
[FIG. 27] FIG. 27 is a schematic cross-sectional diagram illustrating an example of a configuration of an imaging element according to Modification Example 6 of the present disclosure.
[FIG. 28] FIG. 28 is a block diagram illustrating a configuration of an imaging device including, as a pixel, the imaging element illustrated in, for example, FIG. 1.
[FIG. 29] FIG. 29 is a functional block diagram illustrating an example of an electronic apparatus (camera) including the imaging device illustrated in FIG. 28.
[FIG. 30A] FIG. 30A is a schematic diagram illustrating an example of an overall configuration of a photodetection system including the imaging device illustrated in FIG. 38.
[FIG. 30B] FIG. 30B is a diagram illustrating an example of a circuit configuration of the photodetection system illustrated in FIG. 30A.
[FIG. 31] FIG. 31 is a view depicting an example of a schematic configuration of an endoscopic surgery system.
[FIG. 32] FIG. 32 is a block diagram depicting an example of a functional configuration of a camera head and a camera control unit (CCU).
[FIG. 33] FIG. 33 is a block diagram depicting an example of schematic configuration of a vehicle control system.
[FIG. 34] FIG. 34 is a diagram of assistance in explaining an example of installation positions of an outside-vehicle information detecting section and an imaging section.

### Modes for Carrying Out the Invention

In the following, a description is given of an embodiment of the present disclosure in detail with reference to the drawings. The following description is merely a specific example of the present disclosure, and the present disclosure should not be limited to the following embodiments. Moreover, the present disclosure is not limited to arrangements, dimensions, dimensional ratios, and the like of each component illustrated in the drawings. It is to be noted that the description is given in the following order.
1. First Embodiment (Example of Imaging Element Having Protective Layer Including Plurality of Layers with Different Composition Ratios)
   1-1. Configuration of Imaging Element
   1-2. Method of Manufacturing Imaging Element
   1-3. Signal Acquisition Operation of Imaging Element
   1-4. Workings and Effects
2. Second Embodiment (Example of Imaging Element in Which Layer Having Opening Is Added on Accumulation Electrode as Protective Layer)
   2-1. Configuration of Photoelectric Converter
   2-2. Workings and Effects
3. Modification Examples
   2-1. Modification Example 1 (Another Example of Configuration of Photoelectric Converter)
   2-2. Modification Example 2 (Another Example of Configuration of Photoelectric Converter)
   2-3. Modification Example 3 (Another Example of Configuration of Photoelectric Converter)
   3-4. Modification Example 4 (Example of Imaging Element That Performs Spectroscopy Using Color Filter)
   3-5. Modification Example 5 (Another Example of Imaging Element That Performs Spectroscopy Using Color Filter)
   3-6. Modification Example 6 (Example of Imaging Element in Which Plurality of Photoelectric Converters Are Stacked)
4. Application Examples
5. Practical Application Examples

### <1. First Embodiment>

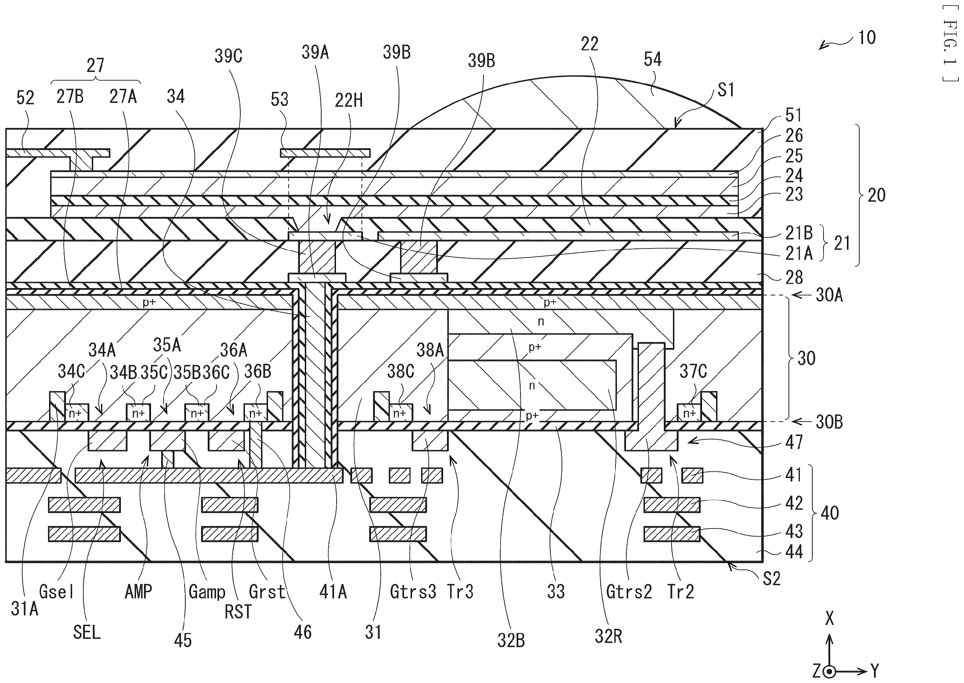

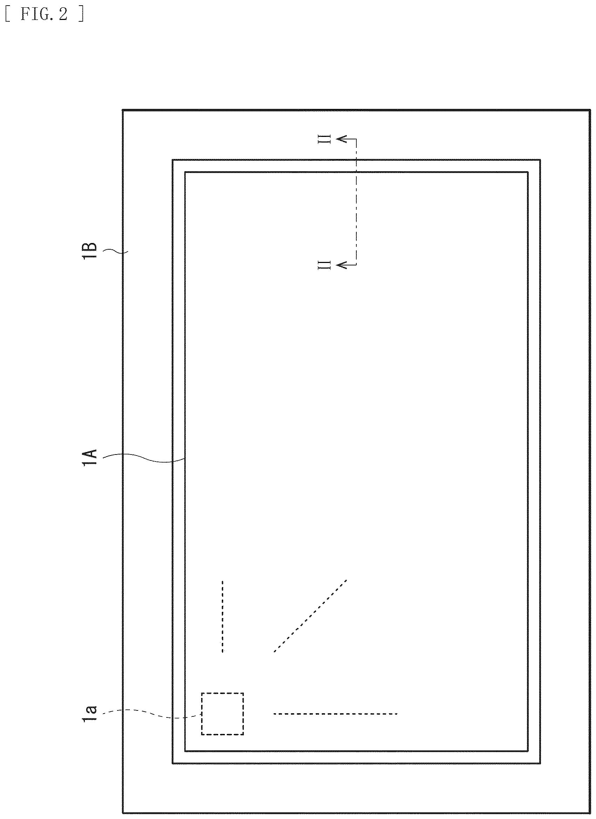

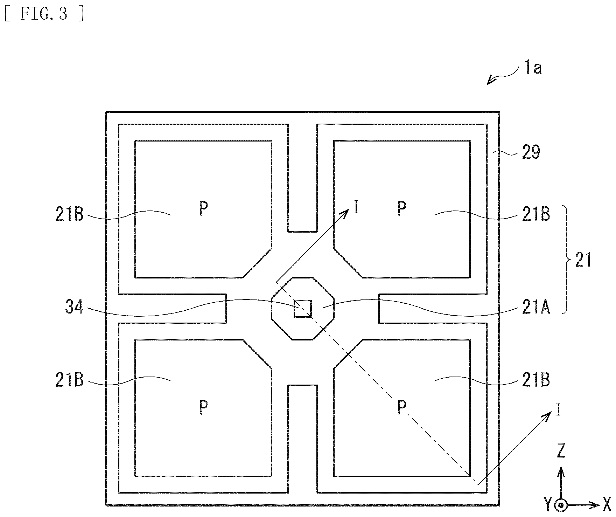

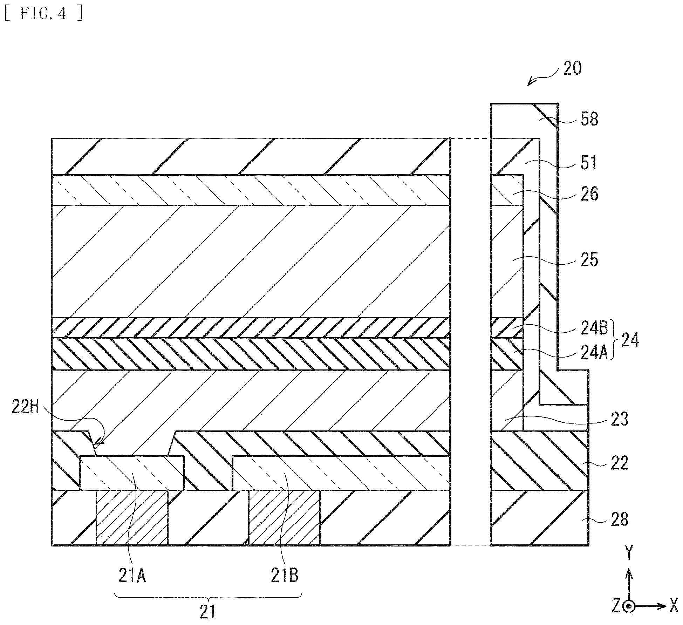

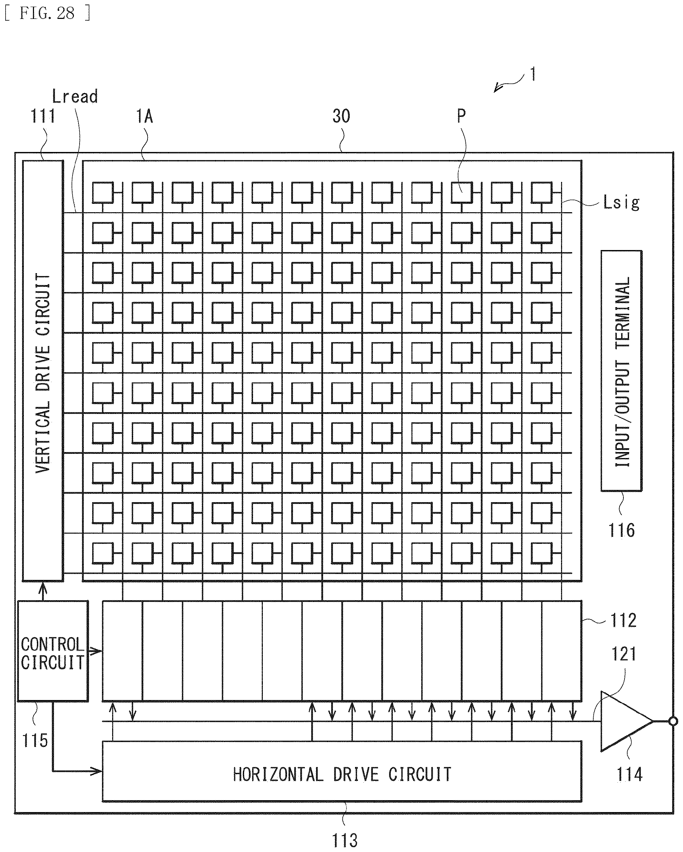

FIG. 1 illustrates a cross-sectional configuration of an imaging element (an imaging element 10) according to a first embodiment of the present disclosure. The imaging element 10 constitutes, for example, one pixel (a unit pixel P) repeatedly arranged in an array in a pixel section 1A of an imaging device (for example, an imaging device 1, see FIG. 28) such as a CMOS (Complementary Metal Oxide Semiconductor) image sensor to be used in an electronic apparatus such as a digital still camera or a video camera. FIG. 2 schematically illustrates a planar configuration of the imaging device 1 that includes the imaging element 10 illustrated in FIG. 1. FIG. 3 schematically illustrates an example of a pixel configuration of the imaging device 1 including the imaging element 10 illustrated in FIG. 1. FIG. 1 illustrates a cross-section taken along line I-I illustrated in FIG. 3. FIG. 4 schematically illustrates an example of an enlarged cross-sectional configuration of a main part (a photoelectric converter 20) of the imaging element 10 illustrated in FIG. 1 and a boundary between the pixel section 1A and a peripheral region 1B. FIG. 4 illustrates a cross-section taken along line II-II illustrated in FIG. 2. In the pixel section 1A, as illustrated in FIG. 3, a pixel unit 1a including four unit pixels P arranged in, for example, two rows × two columns serves as a repeating unit, and is repeatedly arranged in an array including a row direction and a column direction.

The imaging element 10 of the present embodiment includes the photoelectric converter 20 provided on a semiconductor substrate 30. In the photoelectric converter 20, a lower electrode 21 including a readout electrode 21A and an accumulation electrode 21B, an insulating layer 22, an oxide semiconductor layer 23, a protective layer 24, a photoelectric conversion layer 25, and an upper electrode 26 are stacked in this order. The protective layer 24 includes a plurality of layers, and has, for example, a configuration in which a first layer 24A and a second layer 24B having different composition ratios are stacked in this order from a side of the oxide semiconductor layer 23. The readout electrode 21A corresponds to a specific example of a "second electrode" of the present disclosure, and the accumulation electrode 21B corresponds to a specific example of a "first electrode" of the present disclosure. Further, the first layer 24A corresponds to a specific example of a "first layer" of the present disclosure, and the second layer 24B corresponds to a specific example of a "second layer" of the present disclosure.

### (1-1. Configuration of Imaging Element)

The imaging element 10 is, for example, what is called a vertical spectral type in which one photoelectric converter 20 and two photoelectric conversion regions 32B and 32R are stacked in a vertical direction. The photoelectric converter 20 is provided on a side of a back surface (a first surface 30A) of the semiconductor substrate 30. The photoelectric conversion regions 32B and 32R are embedded and formed in the semiconductor substrate 30, and are stacked in a thickness direction of the semiconductor substrate 30.

The photoelectric converter 20 and the photoelectric conversion regions 32B and 32R selectively detect light in wavelength ranges different from each other and perform photoelectric conversion. For example, the photoelectric converter 20 acquires a green (G) color signal. The photoelectric conversion regions 32B and 32R respectively acquire blue (B) and red (R) color signals depending on a difference in an absorption coefficient. This makes it possible for the imaging element 10 to acquire a plurality of kinds of color signals in one pixel without using color filters.

It is to be noted that, in the present embodiment, a description is given of a case where electrons, out of pairs (excitons) of electrons and holes generated by photoelectric conversion, are read out as signal charges (a case where an n-type semiconductor region is used as a photoelectric conversion layer). Further, in the drawing, "+ (plus)" attached to "p" and "n" indicates that the p-type or n-type impurity concentration is high.

On a front surface (a second surface 30B) of the semiconductor substrate 30, for example, a floating diffusion (a floating diffusion layer) FD1 (a region 36B in the semiconductor substrate 30), a FD2 (a region 37C in the semiconductor substrate 30), a FD3 (a region 38C in the semiconductor substrate 30), transfer transistors Tr2 and Tr3, an amplifier transistor (a modulation element) AMP, a reset transistor RST, and a selection transistor SEL are provided. A multilayer wiring layer 40 is further provided on the second surface 30B of the semiconductor substrate 30 with a gate insulating layer 33 interposed therebetween. The multilayer wiring layer 40 has, for example, a configuration in which wiring layers 41, 42, and 43 are stacked in an insulating layer 44. A vertical drive circuit 111, a column signal processing circuit 112, a horizontal drive circuit 113, an output circuit 114, a control circuit 115, an input/output terminal 116, and the like, which will be described later, are provided in a peripheral part of the semiconductor substrate 30, that is, in the peripheral region 1B around the pixel section 1A.

It is to be noted that, in the drawings, a side of the first surface 30A of the semiconductor substrate 30 is referred to as a light incident side S1, and a side of the second surface 30B is referred to as a wiring layer side S2.

In the photoelectric converter 20, the oxide semiconductor layer 23, the protective layer 24 including an inorganic material, and the photoelectric conversion layer 25 including an organic material are stacked in this order from a side of the lower electrode 21 between the lower electrode 21 and the upper electrode 26 that are disposed to oppose each other. As described above, in the protective layer 24, the first layer 24A and the second layer 24B having different composition ratios are stacked in this order from the side of the oxide semiconductor layer 23. The photoelectric conversion layer 25 includes a p-type semiconductor and an n-type semiconductor, and has a bulk heterojunction structure in the layer. The bulk heterojunction structure is a pin junction surface formed by mixing the p-type semiconductor and the n-type semiconductor.

The photoelectric converter 20 further includes the insulating layer 22 between the lower electrode 21 and the oxide semiconductor layer 23. The insulating layer 22 is provided over, for example, an overall surface of the pixel section 1A and also has an opening 22H above the readout electrode 21A constituting the lower electrode 21. The readout electrode 21A is electrically coupled to the oxide semiconductor layer 23 through the opening 22H.

It is to be noted that, although FIG. 1 illustrates an example in which the oxide semiconductor layer 23, the photoelectric conversion layer 25, and the upper electrode 26 are separately formed for each imaging element 10, the oxide semiconductor layer 23, the photoelectric conversion layer 25, and the upper electrode 26 may be provided as, for example, continuous layers common to a plurality of imaging elements 10.

For example, an insulating layer 27 and an interlayer insulating layer 28 are stacked between the first surface 30Aof the semiconductor substrate 30 and the lower electrode 21. In the insulating layer 27, a layer (fixed charge layer) 26A having a fixed charge and a dielectric layer 27B having an insulation property are stacked in this order from a side of the semiconductor substrate 30.

It is possible for the photoelectric conversion regions 32B and 32R to disperse light in the vertical direction using the fact that the wavelengths of light absorbed in the semiconductor substrate 30 including a silicon substrate differ in accordance with the incidence depth of light. Each of the photoelectric conversion regions 32B and 32R has a pn junction in a predetermined region of the semiconductor substrate 30.

A through-electrode 34 is provided between the first surface 30A and the second surface 30B of the semiconductor substrate 30. The through-electrode 34 is electrically coupled to the readout electrode 21A. The photoelectric converter 20 is coupled to a gate Gamp of the amplifier transistor AMP and one source/drain region 36B of the reset transistor RST (a reset transistor Trirst) that also serves as the floating diffusion FD1 via the through-electrode 34. This makes it possible for the imaging element 10 to favorably transfer carriers (here, electrons) generated in the photoelectric converter 20 provided on the side of the first surface 30A of the semiconductor substrate 30 to the side of the second surface 30B of the semiconductor substrate 30 via the through-electrode 34, thereby enhancing the characteristics.

A lower end of the through-electrode 34 is coupled to a wiring (a coupling section 41A) in the wiring layer 41. The coupling section 41A and the gate Gamp of the amplifier transistor AMP are coupled to each other via a lower first contact 45. The coupling section 41A and the floating diffusion FD1 (the region 36B) are coupled to each other via, for example, a lower second contact 46. An upper end of the through-electrode 34 is coupled to the readout electrode 21A via, for example, a pad section 39A and an upper first contact 39C.

A protective layer 51 is provided above the photoelectric converter 20. In the protective layer 51, for example, a wiring 52 and a light shielding film 53 are provided that electrically couple the upper electrode 26 to a peripheral circuit section 130 around the pixel section 1A. A planarization layer (not illustrated) or an optical member such as an on-chip lens 54 is further disposed above the protective layer 51.

In the imaging element 10 of the present embodiment, the light that has entered the photoelectric converter 20 from the light incident side S1 is absorbed by the photoelectric conversion layer 25. The excitons thus generated migrate to an interface between the electron donor and the electron acceptor constituting the photoelectric conversion layer 25, and undergo exciton separation, i.e., dissociate into electrons and holes. The carriers (electrons and holes) generated here are transported to respective different electrodes by diffusion due to a concentration difference between the carriers and by an internal electric field due to a difference in work functions between an anode (for example, the upper electrode 26) and a cathode (for example, the lower electrode 21), and are detected as photocurrents. Further, it is possible to control a direction in which the electrons and holes are transported also by applying a potential between the lower electrode 21 and the upper electrode 26.

Hereinafter, a description is given in detail of configurations, materials, and the like of each section.

The photoelectric converter 20 is an organic photoelectric conversion element that absorbs, for example, green light corresponding to a portion or all of a wavelength range of a selective wavelength range (for example, 450 nm or more and 650 nm or less), and causes excitons to be generated.

The lower electrode 21 includes, for example, the readout electrode 21A and the accumulation electrode 21B disposed side by side on the interlayer insulating layer 28. The readout electrode 21A transfers carriers generated in the photoelectric conversion layer 25 to the floating diffusion FD1, and is provided one for each pixel unit 1a including four pixels arranged in, for example, two rows × two columns.

The readout electrode 21A is coupled to the floating diffusion FD1 via, for example, the upper first contact 39C, the pad section 39A, the through-electrode 34, the coupling section 41A, and the lower second contact 46.

The accumulation electrode 21B accumulates, out of the carriers generated in the photoelectric conversion layer 25, for example, electrons as signal charges in the oxide semiconductor layer 23. The accumulation electrode 21B is provided for each pixel. The accumulation electrode 21B opposes, for each unit pixel P, light-receiving surfaces of the photoelectric conversion regions 32B and 32R formed in the semiconductor substrate 30, and is provided in a region covering the light-receiving surfaces. The accumulation electrode 21B is preferably larger than the readout electrode 21A to make it possible to accumulate many carriers.

The lower electrode 21 includes a light permeable electrically conductive film, and includes, for example, ITO (indium tin oxide). As a constituent material of the lower electrode 21, in addition to the ITO, a tin oxide (SnO₂)-based material doped with a dopant, or a zinc oxide-based material obtained by doping zinc oxide (ZnO) with a dopant may be used. Examples of the zinc oxide-based material include aluminum zinc oxide (AZO) doped with aluminum (Al) as a dopant, gallium zinc oxide (GZO) doped with gallium (Ga), and indium zinc oxide (IZO) doped with indium (In). Further, in addition to the above, IGZO, ITZO, CuI, InSbO₄, ZnMgO, CuInO₂, MgIN₂O₄, CdO, ZnSnO₃, etc. may be used.

The insulating layer 22 electrically separates the accumulation electrode 21B from the oxide semiconductor layer 23. The insulating layer 22 is provided, for example, on the interlayer insulating layer 28 to cover the lower electrode 21. The insulating layer 22 is provided with the opening 22H above the readout electrode 21A of the lower electrode 21, and the readout electrode 21A and the oxide semiconductor layer 23 are electrically coupled through the opening 22H. The insulating layer 22 includes, for example, a monolayer film including one of silicon oxide (SiOₓ), silicon nitride (SiNₓ), silicon oxynitride (SiON), etc., or a stacked film including two or more thereof. The insulating layer 22 has a thickness of, for example, 20 nm to 500 nm.

The oxide semiconductor layer 23 accumulates the carriers generated in the photoelectric conversion layer 25. The oxide semiconductor layer 23 may include an oxide semiconductor material including at least one element out of, for example, indium (In), gallium (Ga), silicon (Si), zinc (Zn), aluminum (Al), and tin (Sn). In the present embodiment, electrons out of the carriers generated in the photoelectric conversion layer 25 are used as signal charges. Accordingly, the oxide semiconductor layer 23 may include an n-type oxide semiconductor material. Specifically, the constituent material of the oxide semiconductor layer 23 may include IGZO, Ga₂O₃, GZO, IZO, ITO, InGaAlO, InGaSiO, etc. The oxide semiconductor layer 23 has a thickness of, for example, 10 nm to 300 nm.

The protective layer 24 prevents oxygen from being desorbed from the oxide semiconductor layer 23. The protective layer 24 has the first layer 24A and the second layer 24B that are sequentially stacked from the side of the oxide semiconductor layer 23. The first layer 24A and the second layer 24B have composition ratios different from each other. Specifically, the first layer 24A and the second layer 24B include oxygen (O), an element X, and an element Y as a common element and satisfy Rₓ₁ > Rₓ₂ ≥ 0 and 0 ≤ R_{y1} < R_{y2} in a case where the composition ratio of the element X and the element Y is defined as the number of atoms of each of the element X and the element Y divided by the total number of atoms of the element X and the element Y, and where the composition ratio of the element X included in the first layer is referred to as Rₓ₁, the composition ratio of the element Y included in the first layer is referred to as R_{y1}, the composition ratio of the element X included in the second layer is referred to as Rₓ₂, and the composition ratio of the element Y included in the second layer is referred to as R_{y2}.

In general, at an interface between the oxide semiconductor layer 23 and a protective film including an inorganic material, defects occur on a surface of the oxide semiconductor layer 23 when the protective film is formed. It is possible to terminate the defects by introducing an element such as oxygen, fluorine, hydrogen, or deuterium from the protective film. It is therefore preferable that the first layer 24A be readily permeable to these elements. On the other hand, elements such as oxygen, fluorine, hydrogen, or deuterium are easily desorbed through the protective film. It is therefore preferable that the second layer 24B impermeable to these elements be stacked on the first layer 24A. That is, it is preferable that the first layer 24A and the second layer 24B have a sufficiently different density. For example, by adopting the following configuration, it is possible to terminate interface defects between the oxide semiconductor layer 23 and the protective layer 24 and to suppress desorption of terminated elements.

A difference between the composition ratio Rₓ₁ of the element X in the first layer 24A and the composition ratio Rₓ₂ of the element X in the second layer 24B is preferably 0.1 or more. It is preferable that the first layer 24A have a film thickness of 1 atomic layer or more and 5 nm or less, the second layer 24B have a film thickness of 1 nm or more and 10 nm or less, and the total film thickness of the first layer 24A and the second layer 24B be less than 10 nm. It is preferable that the first layer 24A have a film density of 3.0 g/cm³ or less, and the second layer 24B have a film density of 2.5 g/cm³ or more.

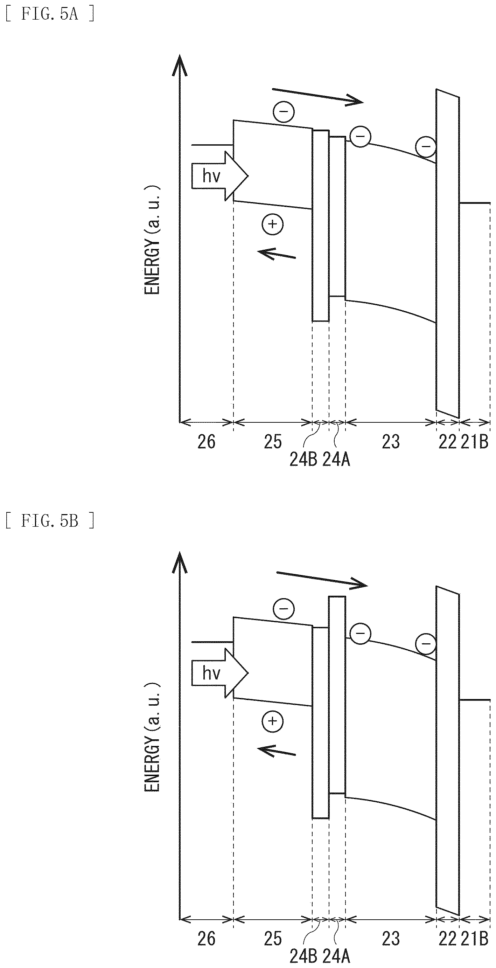

FIGs. 5A and 5B illustrate examples of energy levels of the insulating layer 22, the oxide semiconductor layer 23, the protective layer 24 (the first layer 24A and the second layer 24B), the photoelectric conversion layer 25, and the upper electrode 26 stacked above the accumulation electrode 21B. In a case where it is defined that the further it is from a vacuum level, the higher (the deeper) the energy is on the assumption that the vacuum level is a zero reference, and where the energy level at a lowermost end of a conduction band of the photoelectric conversion layer 25 is referred to as Eco, the energy level at a lowermost end of a conduction band of the oxide semiconductor layer 23 is referred to as Ecc, the energy level at a lowermost end of a conduction band of the first layer 24A is referred to as Ec_{A}, and the energy level at a lowermost end of a conduction band of the second layer 24B is referred to as Ec_{B}, Eco ≤ Ec_{B} ≤ Ec_{A} ≤ Ec_{C} is preferably satisfied.

As a result, the carriers (the electrons) generated in the photoelectric conversion layer 25 are transported to the side of the accumulation electrode 21B in accordance with an energy gradient. Thereafter, the electrons accumulated at the upper part of the accumulation electrode 21B are transferred to the readout electrode 21A and further transferred to the floating diffusion FD1 by controlling the potential of the accumulation electrode 21B to generate a potential gradient.

It is to be noted that, when the film thickness of the first layer 24A is less than 1 nm, even in a case where the energy level Ec_{A} at the lowermost end of the conduction band of the first layer 24A is lower (shallower) than the energy level Eco at the lowermost end of the conduction band of the photoelectric conversion layer 25 and the energy level Ec_{B} at the lowermost end of the conduction band of the second layer 24B as illustrated in FIG. 5B, the electrons generated in the photoelectric conversion layer 25 are transported to the side of the accumulation electrode 21B.

The protective layer 24 may include a metal oxide including at least one element out of, for example, tantalum (Ta), titanium (Ti), vanadium (V), niobium (Nb), tungsten (W), zirconium (Zr), hafnium (Hf), scandium (Sc), yttrium (Y), lanthanum (La), gallium (Ga), and magnesium (Mg). Specifically, examples of the constituent material of the protective layer 24 include tantalum oxide (Ta₂O₅), titanium oxide (TiO₂), vanadium oxide (V₂O₅), niobium oxide (Nb₂O₅), tantalum oxide (W₂O₃), zirconium oxide (ZrO₂), hafnium oxide (HfO₂), scandium oxide (Sc₂O₃), yttrium oxide (Y₂O₃), lanthanum oxide (La₂O₃), gallium oxide (Ga₂O₃), and magnesium oxide (MgO).

It is to be noted that, in a case where the film thickness of the first layer 24A is less than 1 nm, the first layer 24A may include SiOₓ, SiON, SiOC, or AlOₓ.

The photoelectric conversion layer 25 converts light energy into electric energy. The photoelectric conversion layer 25 includes, for example, two or more kinds of organic materials (p-type semiconductor materials or n-type semiconductor materials) each functioning as a p-type semiconductor or an n-type semiconductor. The photoelectric conversion layer 25 has a junction surface (the p/n junction surface) between the p-type semiconductor material and the n-type semiconductor material in the layer. The p-type semiconductor functions relatively as an electron donor (donor), and the n-type semiconductor functions relatively as an electron acceptor (acceptor). The photoelectric conversion layer 25 provides a field in which excitons generated when absorbing light are separated into electrons and holes. Specifically, excitons are separated into electrons and holes at the interface (the pin junction surface) between the electron donor and the electron acceptor.

The photoelectric conversion layer 25 may include, in addition to the p-type semiconductor material and the n-type semiconductor material, an organic material that photoelectrically converts light in a predetermined wavelength range while transmitting light in another wavelength range, or what is called a dye material. In a case where the photoelectric conversion layer 25 includes three kinds of organic materials, i.e., the p-type semiconductor material, the n-type semiconductor material, and the dye material, the p-type semiconductor material and the n-type semiconductor material are preferably materials having light permeability in a visible region (e.g., 450 nm to 800 nm). The photoelectric conversion layer 25 has a thickness of, for example, 50 nm to 500 nm.

Examples of the organic material constituting the photoelectric conversion layer 25 include quinacridone derivatives, naphthalene derivatives, anthracene derivatives, phenanthrene derivatives, tetracene derivatives, pyrene derivatives, perylene derivatives, and fluoranthene derivatives. The photoelectric conversion layer 25 is configured by combining two or more kinds of the above-described organic materials. The organic materials function as the p-type semiconductor or the n-type semiconductor depending on the combination thereof.

It is to be noted that the organic material constituting the photoelectric conversion layer 25 is not particularly limited. In addition to the organic materials described above, for example, a polymer such as phenylenevinylene, fluorene, carbazole, indole, pyrene, pyrrole, picoline, thiophene, acetylene, and diacetylene, or a derivative thereof may be used. Alternatively, a condensed polycyclic aromatic compound such as a metal complex dye, a cyanine-based dye, a merocyanine-based dye, a phenylxanthene-based dye, a triphenylmethane-based dye, a rhodacyanine-based dye, a xanthene-based dye, a macrocyclic azaannulene-based dye, an azulene-based dye, a naphthoquinone-based dye, an anthraquinone-based dye, or pyrene, a chain compound in which an aromatic ring or a heterocyclic compound is condensed, a quinoline having a squarylium group and a croconic methine group as a bond chain, two nitrogen-containing heterocycles such as a benzothiazole or a benzoxazole, or a cyanine-based similar dye bonded by a squarylium group and a croconic methine group, or the like may be used. It is to be noted that the metal complex dye may include a dithiol metal complex-based dye, a metal phthalocyanine dye, a metal porphyrin dye, or a ruthenium complex dye. Of these, ruthenium complex dyes are particularly preferred, but the present disclosure is not limited to the above.

Similarly to the lower electrode 21, the upper electrode 26 includes a light permeable electrically conductive film, and includes, for example, ITO (indium tin oxide). As a constituent material of the upper electrode 26, in addition to the ITO, a tin oxide (SnO₂)-based material doped with a dopant, or a zinc oxide-based material obtained by doping zinc oxide (ZnO) with a dopant may be used. Examples of the zinc oxide-based material include aluminum zinc oxide (AZO) doped with aluminum (Al) as a dopant, gallium zinc oxide (GZO) doped with gallium (Ga), and indium zinc oxide (IZO) doped with indium (In). Further, in addition to the above, IGZO, ITZO, CuI, InSbO₄, ZnMgO, CuInO₂, MgIN₂O₄, CdO, ZnSnO₃, etc. may be used. The upper electrode 26 may be separated for each pixel or may be formed as an electrode common to each pixel. The upper electrode 26 has a thickness of, for example, 10 nm to 200 nm.

It is to be noted that, in the photoelectric converter 20, another layer may be provided between the lower electrode 21 and the photoelectric conversion layer 25 (for example, between the protective layer 24 and the photoelectric conversion layer 25) and between the photoelectric conversion layer 25 and the upper electrode 26. For example, in the photoelectric converter 20, layers such as the protective layer 24, a buffer layer that also serves as an electron blocking film, the photoelectric conversion layer 25, a buffer layer that also serves as a hole blocking film, and a work function adjustment layer may be stacked in this order from the side of the lower electrode 21. Further, the photoelectric conversion layer 25 may have, for example, a pin bulk-heterostructure in which a p-type blocking layer, a layer (i-layer) including a p-type semiconductor and an n-type semiconductor, and an n-type blocking layer are stacked.

The insulating layer 27 covers the first surface 30A of the semiconductor substrate 30, reduces an interface state with the semiconductor substrate 30, and suppresses generation of dark current from an interface with the semiconductor substrate 30. Further, the insulating layer 27 extends along a side surface of an opening 34H (see FIG. 1) in which the through-electrode 34 is formed that extends through the semiconductor substrate 30 from the first surface 30A of the semiconductor substrate 30. The insulating layer 27 has, for example, a stacked structure of a fixed charge layer 27A and a dielectric layer 27B.

The fixed charge layer 27A may be a film having a positive fixed charge or a film having a negative fixed charge. A constituent material of the fixed charge layer 27A preferably includes a semiconductor material or an electrically conductive material having a wider band gap than that of the semiconductor substrate 30. This makes it possible to reduce the generation of dark current at the interface of the semiconductor substrate 30. Examples of the constituent material of the fixed charge layer 27A include hafnium oxide (HfOₓ), aluminum oxide (AlOₓ), zirconium oxide (ZrOₓ), tantalum oxide (TaOₓ), titanium oxide (TiOₓ), lanthanum oxide (LaOₓ), praseodymium oxide (PrOₓ), cerium oxide (CeOₓ), neodymium oxide (NdOₓ), promethium oxide (PmOₓ), samarium oxide (SmOₓ), europium oxide (EuOₓ), gadolinium oxide (GdOₓ), terbium oxide (TbOₓ), dysprosium oxide (DyOₓ), holmium oxide (HoOₓ), thulium oxide (TmOₓ), ytterbium oxide (YbOₓ), lutetium oxide (LuOₓ), yttrium oxide (YOₓ), hafnium nitride (HfNₓ), aluminum nitride (AlNₓ), hafnium oxynitride (HfOₓN_{y}), aluminum oxynitride (AlOₓN_{y}), etc.

The dielectric layer 27B prevents optical reflection caused by a difference in a refractive index between the semiconductor substrate 30 and the interlayer insulating layer 28. The constituent material of the dielectric layer 27B is preferably a material having a refractive index that is between the refractive index of the semiconductor substrate 30 and the refractive index of the interlayer insulating layer 28. Examples of the constituent material of the dielectric layer 27B include silicon oxide, TEOS, silicon nitride, silicon oxynitride (SiON), etc.

The interlayer insulating layer 28 includes, for example, a monolayer film including one of silicon oxide, silicon nitride, silicon oxynitride, or the like, or a stacked film including two or more thereof.

A shield electrode 29 is provided on the interlayer insulating layer 28 together with the lower electrode 21. The shield electrode 29 prevents capacitive coupling between adjacent pixel units 1a, and is provided, for example, around each pixel unit 1a including four pixels arranged in two rows × two columns. A fixed potential is applied to the shield electrode 29. The shield electrode 29 further extends between pixels adjacent to each other in the row direction (a Z-axis direction) and the column direction (an X-axis direction) in the pixel unit 1a.

The semiconductor substrate 30 includes, for example, an n-type silicon (Si) substrate, and has a p-well 31 in a predetermined region.

The photoelectric conversion regions 32B and 32R each include a photodiode (PD) having a pn junction in a predetermined region of the semiconductor substrate 30. It is possible for the photoelectric conversion regions 32B and 32R to disperse light in the vertical direction using the fact that the wavelengths of light absorbed in the Si substrate differ in accordance with the incidence depth of light. The photoelectric conversion region 32B selectively detects blue light and accumulates signal charges corresponding to blue light, for example. The photoelectric conversion region 32B is installed at a depth at which it is possible to photoelectrically convert blue light efficiently. The photoelectric conversion region 32R selectively detects red light and accumulates signal charges corresponding to red light, for example. The photoelectric conversion region 32R is installed at a depth at which it is possible to photoelectrically convert red light efficiently. It is to be noted that blue (B) is a color corresponding to a wavelength range of 450 nm to 495 nm, for example, and red (R) is a color corresponding to a wavelength range of 620 nm to 750 nm, for example. It is sufficient for each of the photoelectric conversion regions 32B and 32R to be able to detect light of a portion or all of each wavelength range.

The photoelectric conversion region 32B includes, for example, a p+ region serving as a hole accumulation layer and an n region serving as an electron accumulation layer. The photoelectric conversion region 32R includes, for example, a p+ region serving as a hole accumulation layer and an n region serving as an electron accumulation layer (having a p-n-p stacked structure). The n region of the photoelectric conversion region 32B is coupled to the vertical transfer transistor Tr2. The p+ region of the photoelectric conversion region 32B bends along the transfer transistor Tr2, and is linked to the p+ region of the photoelectric conversion region 32R.

The gate insulating layer 33 includes, for example, a monolayer film including one of silicon oxide, silicon nitride, silicon oxynitride, etc., or a stacked film including two or more thereof.

The through-electrode 34 is provided between the first surface 30A and the second surface 30B of the semiconductor substrate 30, has a function as a connector that couples the photoelectric converter 20 to the gate Gamp of the amplifier transistor AMP and the floating diffusion FD1, and serves as a transmission path for carriers generated in the photoelectric converter 20. A reset gate Grst of the reset transistor RST is located adjacent to the floating diffusion FD1 (the one source/drain region 36B of the reset transistor RST). This makes it possible to reset the carriers accumulated in the floating diffusion FD1 by the reset transistor RST.

The pad section 39A, a pad section 39B, the upper first contact 39C, an upper second contact 39D, the lower first contact 45, the lower second contact 46, and the wiring 52 may include, for example, a doped silicon material such as PDAS (Phosphorus Doped Amorphous Silicon), or a metallic material such as aluminum (Al), tungsten (W), titanium (Ti), cobalt (Co), hafnium (Hf), and tantalum (Ta).

The protective layer 51 and the on-chip lens 54 include a light permeable material, and include, for example, a monolayer film including any one of silicon oxide, silicon nitride, silicon oxynitride, etc., or a stacked film including two or more thereof. The protective layer 51 has a thickness of, for example, 100 nm to 30000 nm.

For example, the light shielding film 53 is provided in the protective layer 51 together with the wiring 52 to cover a region of the readout electrode 21Athat is in direct contact with the oxide semiconductor layer 23 without covering at least the accumulation electrode 21B. The light shielding film 53 may include, for example, tungsten (W), aluminum (Al), an alloy of Al and copper (Cu), etc.

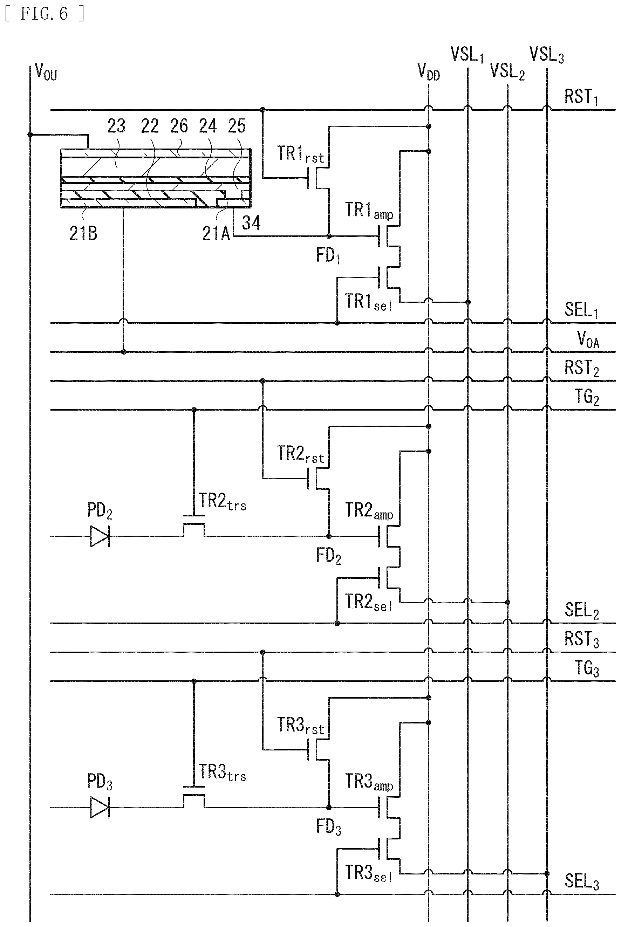

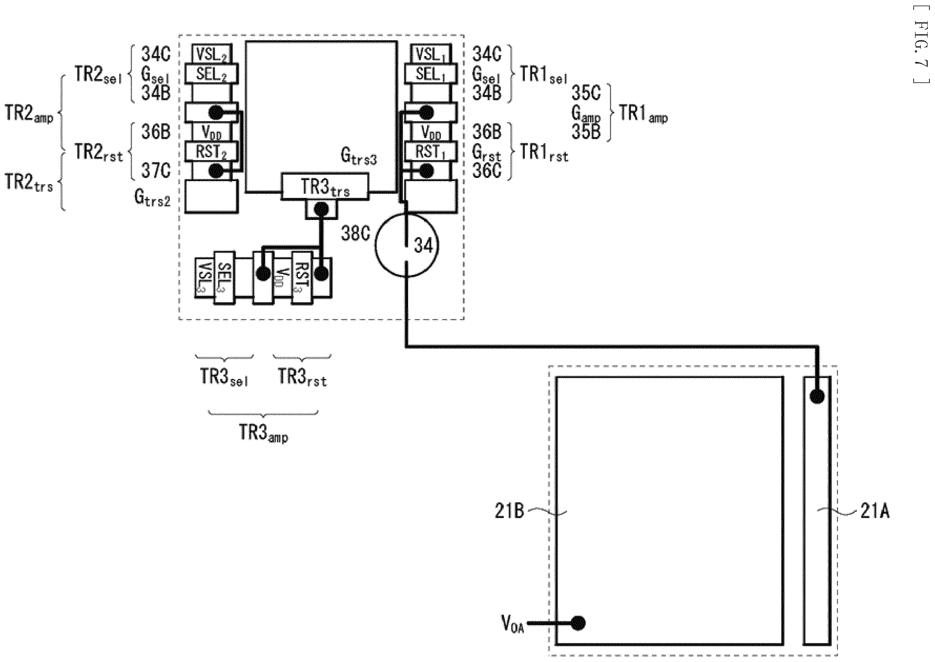

FIG. 6 is an equivalent circuit diagram of the imaging element 10 illustrated in FIG. 1. FIG. 7 schematically illustrates an arrangement of the lower electrode 21 and the transistors constituting the control unit of the imaging element 10 illustrated in FIG. 1.

The reset transistor RST (the reset transistor TR1rst) resets the carriers transferred from the photoelectric converter 20 to the floating diffusion FD1, and includes, for example, a MOS transistor. Specifically, the reset transistor TR1rst includes the reset gate Grst, a channel formation region 36A, the source/drain region 36B, and a source/drain region 36C. The reset gate Grst is coupled to a reset line RST1, and the one source/drain region 36B of the reset transistor TR1rst also serves as the floating diffusion FD1. The other source/drain region 36C constituting the reset transistor TR1rst is coupled to a power supply line VDD.

The amplifier transistor AMP (an amplifier transistor TR1amp) is a modulation element that modulates an amount of charges generated in the photoelectric converter 20 into a voltage, and includes, for example, a MOS transistor. Specifically, the amplifier transistor AMP includes the gate Gamp, a channel formation region 35A, and source/drain regions 35B and 35C. The gate Gamp is coupled to the readout electrode 21A and the one source/drain region 36B (the floating diffusion FD1) of the reset transistor TR1rst via the lower first contact 45, the coupling section 41A, the lower second contact 46, the through-electrode 34, etc. Further, the one source/drain region 35B shares a region with the other source/drain region 36C constituting the reset transistor TR1rst, and is coupled to the power supply line VDD.

A selection transistor SEL (a selection transistor TR1sel) includes a gate Gsel, a channel formation region 34A, and source/drain regions 34B and 34C. The gate Gsel is coupled to a selection line SEL1. The one source/drain region 34B shares a region with the other source/drain region 35C constituting the amplifier transistor AMP, and the other source/drain region 34C is coupled to a signal line (a data output line) VSL1.

The transfer transistor TR2 (a transfer transistor TR2trs) transfers, to the floating diffusion FD2, the signal charges corresponding to a blue color that are generated and accumulated in the photoelectric conversion region 32B. The photoelectric conversion region 32B is formed at a position deeper than the second surface 30B of the semiconductor substrate 30, and it is thus preferable that the transfer transistor TR2trs of the photoelectric conversion region 32B include a vertical transistor. The transfer transistor TR2trs is coupled to a transfer gate line TG2. The floating diffusion FD2 is provided in the region 37C in the vicinity of a gate Gtrs2 of the transfer transistor TR2trs. The carriers accumulated in the photoelectric conversion region 32B are read out to the floating diffusion FD2 via transfer channels formed along the gate Gtrs2.

The transfer transistor TR3 (a transfer transistor TR3trs) transfers, to the floating diffusion FD3, the signal charges corresponding to a red color generated and accumulated in the photoelectric conversion region 32R, and includes, for example, a MOS transistor. The transfer transistor TR3trs is coupled to a transfer gate line TG3. The floating diffusion FD3 is provided in the region 38C in the vicinity of a gate Gtrs3 of the transfer transistor TR3trs. The carriers accumulated in the photoelectric conversion region 32R are read out to the floating diffusion FD3 via transfer channels formed along the gate Gtrs3.

A reset transistor TR2rst, an amplifier transistor TR2amp, and a selection transistor TR2sel that constitute a control unit of the photoelectric conversion region 32B are further provided on the side of the second surface 30B of the semiconductor substrate 30. A reset transistor TR3rst, an amplifier transistor TR3amp, and a selection transistor TR3sel that constitute a control unit of the photoelectric conversion region 32R are further provided.

The reset transistor TR2rst includes a gate, a channel formation region, and source/drain regions. The gate of the reset transistor TR2rst is coupled to a reset line RST2, and one of the source/drain regions of the reset transistor TR2rst is coupled to the power supply line VDD. The other source/drain region of the reset transistor TR2rst also serves as the floating diffusion FD2.

The amplifier transistor TR2amp includes a gate, a channel formation region, and source/drain regions. The gate is coupled to the other source/drain region (the floating diffusion FD2) of the reset transistor TR2rst. One of the source/drain regions constituting the amplifier transistor TR2amp shares a region with one of the source/drain regions constituting the reset transistor TR2rst, and is coupled to the power supply line VDD.

The selection transistor TR2sel includes a gate, a channel formation region, and source/drain regions. The gate is coupled to a selection line SEL2. One of the source/drain regions constituting the selection transistor TR2sel shares a region with the other source/drain region constituting the amplifier transistor TR2amp. The other source/drain region constituting the selection transistor TR2sel is coupled to a signal line (a data output line) VSL2.

The reset transistor TR3rst includes a gate, a channel formation region, and source/drain regions. The gate of the reset transistor TR3rst is coupled to a reset line RST3, and one of the source/drain regions constituting the reset transistor TR3rst is coupled to the power supply line VDD. The other source/drain region constituting the reset transistor TR3rst also serves as the floating diffusion FD3.

The amplifier transistor TR3amp includes a gate, a channel formation region, and source/drain regions. The gate is coupled to the other source/drain region (the floating diffusion FD3) constituting the reset transistor TR3rst. One of the source/drain regions constituting the amplifier transistor TR3amp shares a region with one of the source/drain regions constituting the reset transistor TR3rst, and is coupled to the power supply line VDD.

The selection transistor TR3sel includes a gate, a channel formation region, and source/drain regions. The gate is coupled to a selection line SEL3. One of the source/drain regions constituting the selection transistor TR3sel shares a region with the other source/drain region constituting the amplifier transistor TR3amp. The other source/drain region constituting the selection transistor TR3sel is coupled to a signal line (a data output line) VSL3.

The reset lines RST1, RST2, and RST3, the selection lines SEL1, SEL2, and SEL3, and the transfer gate lines TG2 and TG3 are each coupled to a vertical drive circuit constituting a drive circuit. The signal lines (the data output lines) VSL1, VSL2, and VSL3 are coupled to the column signal processing circuit 112 constituting the drive circuit.

It is to be noted that, in the imaging element 10, the protective layer 51 and an optical black (OPB) layer 58 are formed on the photoelectric converter 20 in the vicinity of the peripheral region 1B provided around the pixel section 1A. For example, as illustrated in FIG. 4, the protective layer 51 and the OPB layer 58 cover side surfaces of the photoelectric converter 20 and extend to the peripheral region 1B. This reduces deterioration caused by damage to the side surfaces of the oxide semiconductor layer 23 when the protective layers 24 and 51 are formed.

### (1-2. Method of Manufacturing Imaging Element)

The imaging element 10 of the present embodiment may be manufactured, for example, as follows.

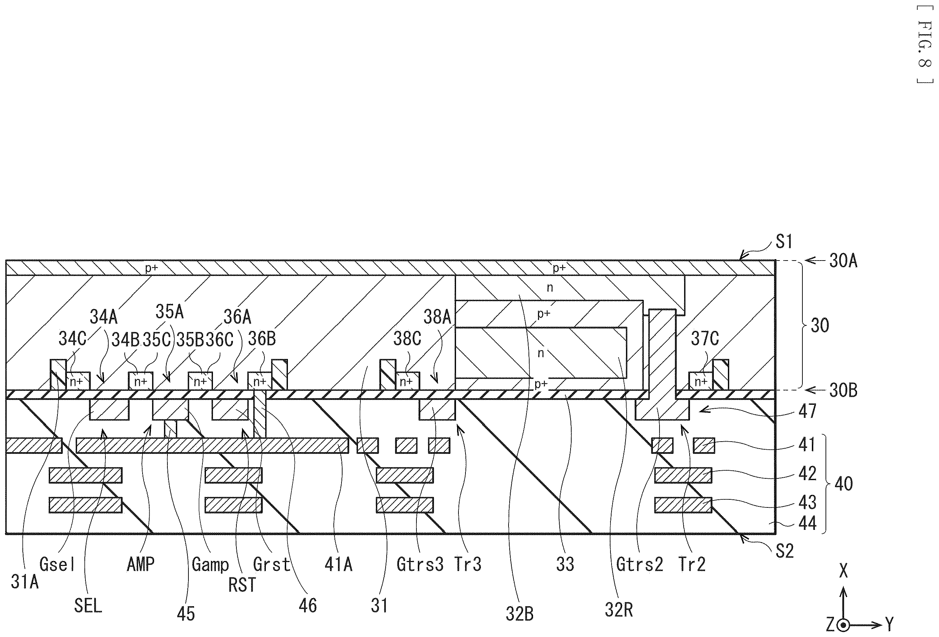

FIGs. 8 to 13 illustrate the method of manufacturing the imaging element 10 in the order of steps. First, as illustrated in FIG. 8, the p-well 31, for example, is formed in the semiconductor substrate 30, and the n-type photoelectric conversion regions 32B and 32R, for example, are formed in the p-well 31. The p+ region is formed in the vicinity of the first surface 30A of the semiconductor substrate 30.

On the second surface 30B of the semiconductor substrate 30, as also illustrated in FIG. 8, for example, n+ regions serving as the floating diffusions FD1 to FD3 are formed. Thereafter, the gate insulating layer 33 and a gate wiring layer 47 including gates of the transfer transistor Tr2, the transfer transistor Tr3, the selection transistor SEL, the amplifier transistor AMP, and the reset transistor RST are formed. As a result, the transfer transistor Tr2, the transfer transistor Tr3, the selection transistor SEL, the amplifier transistor AMP, and the reset transistor RST are formed. Further, the multilayer wiring layer 40 is formed on the second surface 30B of the semiconductor substrate 30. The multilayer wiring layer 40 includes the wiring layers 41 to 43 including the lower first contact 45, the lower second contact 46, and the coupling section 41A, and the insulating layer 44.

As a substrate of the semiconductor substrate 30, for example, a SOI (Silicon on Insulator) substrate in which the semiconductor substrate 30, a buried oxide film (not illustrated), and a holding substrate (not illustrated) are stacked is used. Although not illustrated in FIG. 8, the buried oxide film and the holding substrate are bonded to the first surface 30A of the semiconductor substrate 30. After the ion implantation, an annealing process is performed.

Thereafter, a support substrate (not illustrated) or another semiconductor substrate or the like is bonded on the multilayer wiring layer 40 provided on the side of the second surface 30B of the semiconductor substrate 30, and the substrate is flipped vertically. Thereafter, the semiconductor substrate 30 is separated from the buried oxide film and the holding substrate of the SOI substrate to expose the first surface 30A of the semiconductor substrate 30. It is possible to perform the above steps by techniques used in normal CMOS processing, such as ion implantation and a CVD (Chemical Vapor Deposition) method.

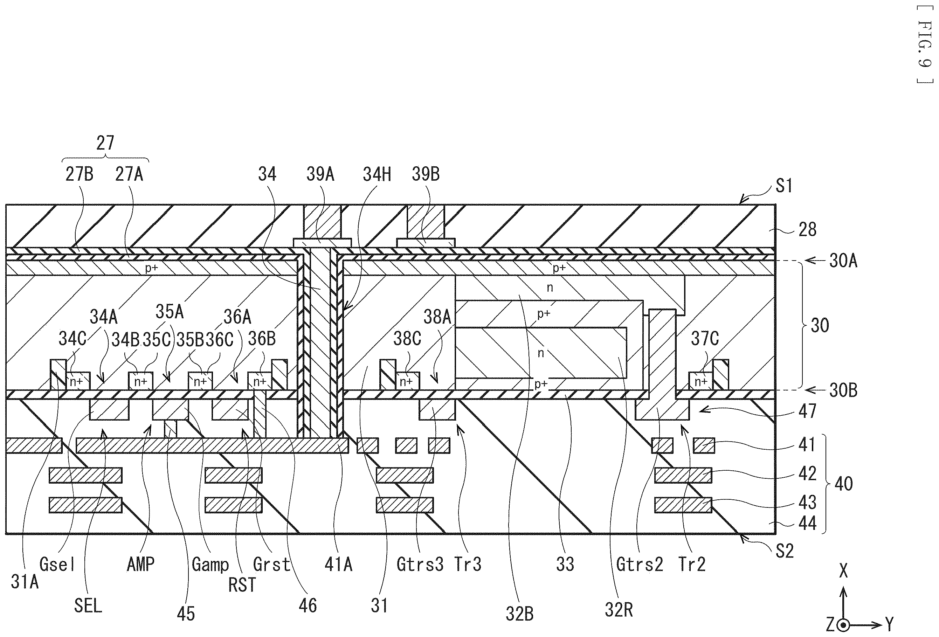

Thereafter, as illustrated in FIG. 9, the semiconductor substrate 30 is processed from the side of the first surface 30A by, for example, dry etching to form the opening 34H that is circular, for example. As for the depth, the opening 34H extends from the first surface 30A to the second surface 30B of the semiconductor substrate 30, and reaches, for example, the coupling section 41A as illustrated in FIG. 9.

Thereafter, for example, the fixed charge layer 27A and the dielectric layer 27B are sequentially formed on the first surface 30A of the semiconductor substrate 30 and the side surface of the opening 34H. The fixed charge layer 27A may be formed, for example, by forming a hafnium oxide film or an aluminum oxide film using an atomic layer deposition method (ALD method). The dielectric layer 27B may be formed, for example, by forming a silicon oxide film using a plasma CVD method. Thereafter, the pad sections 39A and 39B in which a barrier metal including, for example, a stacked film of titanium and titanium nitride (a Ti/TiN film) and a tungsten film are stacked are formed at predetermined positions on the dielectric layer 27B. This makes it possible for the pad sections 39A and 39B to be used as light shielding films. Thereafter, the interlayer insulating layer 28 is formed on the dielectric layer 27B and the pad sections 39A and 39B. The surface of the interlayer insulating layer 28 is planarized by a CMP (Chemical Mechanical Polishing) method.

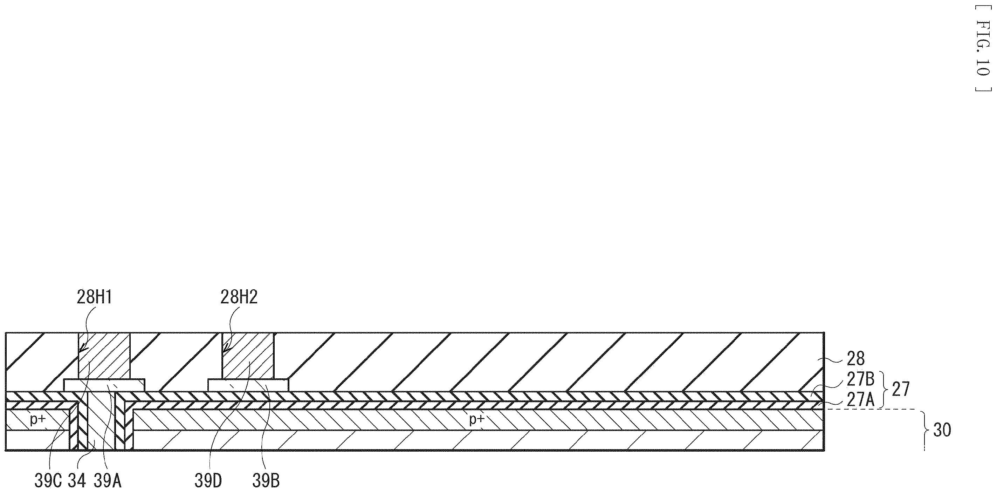

Thereafter, as illustrated in FIG. 10, openings 28H1 and 28H2 are respectively formed above the pad sections 39A and 39B, and then, for example, an electrically conductive material such as Al is embedded in the openings 28H1 and 28H2 to form the upper first contact 39C and the upper second contact 39D.

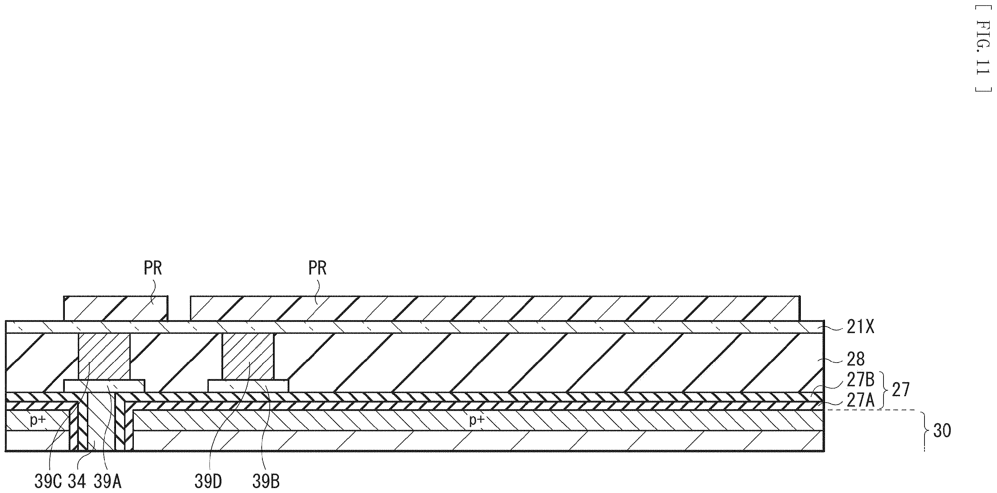

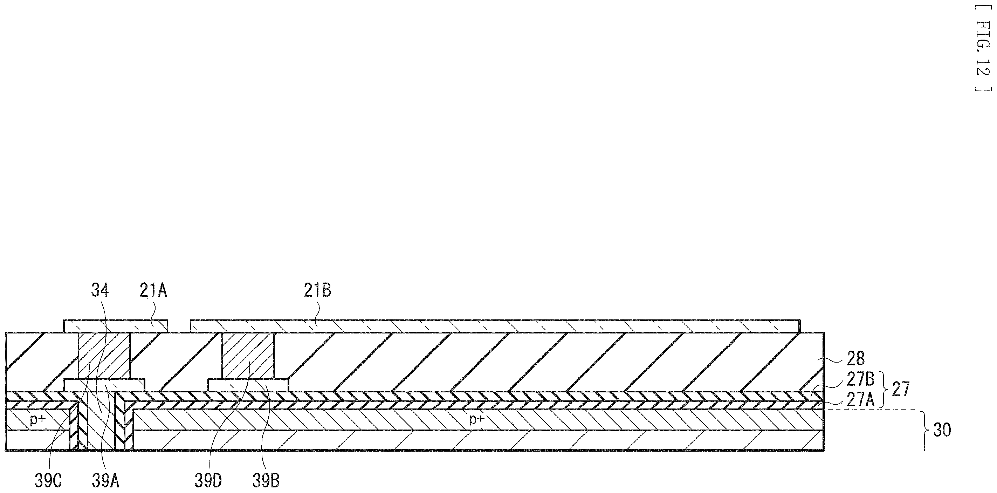

Thereafter, as illustrated in FIG. 11, an electrically conductive film 21x is formed on the interlayer insulating layer 28 using, for example, a sputtering method, and then patterned by a photolithography technique. Specifically, the electrically conductive film 21x is processed by dry etching or wet etching after a photoresist PR is formed at a predetermined position on the electrically conductive film 21x. Thereafter, the photoresist PR is removed to form the readout electrode 21A and the accumulation electrode 21B as illustrated in FIG. 12.

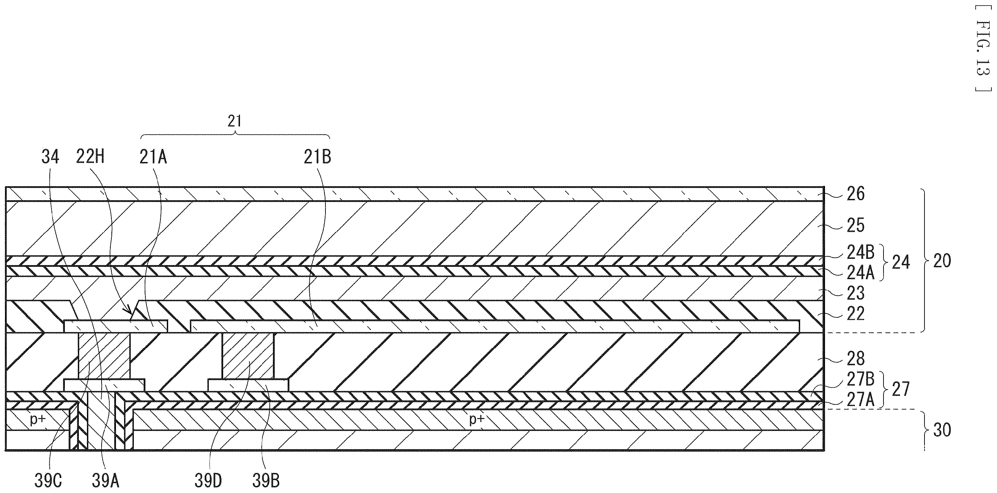

Thereafter, as illustrated in FIG. 13, the insulating layer 22, the oxide semiconductor layer 23, the protective layer 24, the photoelectric conversion layer 25, and the upper electrode 26 are formed. The insulating layer 22 is obtained by forming, for example, a silicon oxide film using the ALD method, and then planarizing the surface of the insulating layer 22 using the CMP method. Thereafter, the opening 22H is formed above the readout electrode 21A by, for example, wet etching. The oxide semiconductor layer 23 may be formed using, for example, the sputtering method. The protective layer 24 (the first layer 24A and the second layer 24B) may be formed using, for example, the ALD method. The photoelectric conversion layer 25 is formed using, for example, a vacuum deposition method. The upper electrode 26 is formed using, for example, the sputtering method in a manner similar to the lower electrode 21. Finally, the protective layer 51 including the wiring 52 and the light shielding film 53 and the on-chip lens 54 are provided on the upper electrode 26. This completes the imaging element 10 illustrated in FIG. 1.

It is to be noted that, as described above, in a case where another layer including an organic material such as a buffer layer also serving as an electron blocking film, a buffer layer also serving as a hole blocking film, or a work function adjustment layer is formed between the protective layer 24 and the photoelectric conversion layer 25 and between the photoelectric conversion layer 25 and the upper electrode 26, it is desirable to form the layers continuously in a vacuum process (by a vacuum consistent process). Further, the method of forming the photoelectric conversion layer 25 is not necessarily limited to a method using the vacuum deposition method, and for example, a spin coating technique, a printing technique, or the like may be used. Further, in addition to the sputtering method, examples of the method of forming the transparent electrode (the lower electrode 21 and the upper electrode 26) may include, although it depends on the material constituting the transparent electrode, a physical vapor deposition method (PVD method) such as a vacuum deposition method, a reactive vapor deposition method, an electron-beam deposition method, and an ion plating method, a pyrosol method, a method of thermally decomposing an organometallic compound, a spraying method, a dipping method, and various CVD methods including a MOCVD method, an electroless plating method, and an electroplating method.

### (1-3. Signal Acquisition Operation of Imaging Element)

In the imaging element 10, when light enters the photoelectric converter 20 through the on-chip lens 54, the light passes through the photoelectric converter 20 and the photoelectric conversion regions 32B and 32R in this order, and is photoelectrically converted for each of color light beams of green (G), blue (B), and red (R) in the passing process. Hereinafter, the signal acquisition operation of each color will be described.

### (Acquisition of Green Signal by Photoelectric Converter 20)

Of the light that has entered the imaging element 10, green light is first selectively detected (absorbed) by the photoelectric converter 20 and photoelectrically converted.

The photoelectric converter 20 is coupled to the gate Gamp and the floating diffusion FD1 of the amplifier transistor TR1amp via the through-electrode 34. Therefore, the electrons of the excitons generated in the photoelectric converter 20 are extracted from the side of the lower electrode 21, transferred to the side of a second surface 30S2 of the semiconductor substrate 30 via the through-electrode 34, and accumulated in the floating diffusion FD1. At the same time, the amplifier transistor TR1amp modulates the amount of charges generated in the photoelectric converter 20 to voltages.

Further, the reset gate Grst of the reset transistor TR1rst is located adjacent to the floating diffusion FD1. As a result, the carriers accumulated in the floating diffusion FD1 are reset by the reset transistor TR1rst.

Because the photoelectric converter 20 is coupled not only to the amplifier transistor TR1amp but also to the floating diffusion FD1 via the through-electrode 34, it is possible to easily reset the carriers accumulated in the floating diffusion FD1 by the reset transistor TR1rst.

In contrast, in a case where the through-electrode 34 and the floating diffusion FD1 are not coupled to each other, it is difficult to reset the carriers accumulated in the floating diffusion FD1, and the carriers are pulled out toward the side of the upper electrode 26 by applying a large voltage. Consequently, the photoelectric conversion layer 25 may possibly be damaged. In addition, a structure that enables resetting in a short period of time leads to an increase in dark noises, resulting in a trade-off. This structure is thus difficult.

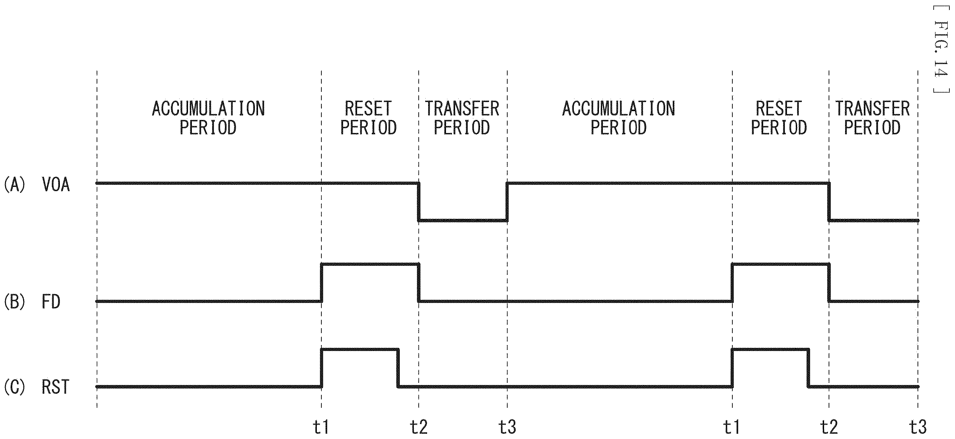

FIG. 14 illustrates an operation example of the imaging element 10. (A) illustrates the potential at the accumulation electrode 21B, (B) illustrates the potential at the floating diffusion FD1 (the readout electrode 21A), and (C) illustrates the potential at the gate (Gsel) of the reset transistor TR1rst. The imaging element 10 is configured to apply voltages individually to the readout electrode 21A and the accumulation electrode 21B.

In the imaging element 10, the drive circuit applies a potential V1 to the readout electrode 21A and applies a potential V2 to the accumulation electrode 21B in an accumulation period. Here, it is assumed that the potentials V1 and V2 satisfy V2 > V1. This allows the carriers (signal charges; electrons) generated through photoelectric conversion to be attracted to the accumulation electrode 21B and to be accumulated in a region of the oxide semiconductor layer 23 opposed to the accumulation electrode 21B (the accumulation period). Incidentally, the value of the potential in the region of the oxide semiconductor layer 23 opposed to the accumulation electrode 21B becomes more negative with the passage of time of photoelectric conversion. It is to be noted that holes are sent from the upper electrode 26 to the drive circuit.

In the imaging element 10, a reset operation is performed in a latter period of the accumulation period. Specifically, at a timing 11, a scanning section changes the voltage of a reset signal RST from a low level to a high level. This brings the reset transistor TR1rst into an ON state in the unit pixel P. As a result, the voltage of the floating diffusion FD1 is set to a power supply voltage, and the voltage of the floating diffusion FD1 is reset (a reset period).

After the reset operation is completed, the carriers are read out. Specifically, the drive circuit applies a potential V3 to the readout electrode 21A and applies a potential V4 to the accumulation electrode 21B at a timing t2. Here, it is assumed that the potentials V3 and V4 satisfy V3 < V4. This allows the carriers accumulated in the region corresponding to the accumulation electrode 21B to be read out from the readout electrode 21A to the floating diffusion FD1. That is, the carriers accumulated in the oxide semiconductor layer 23 are read out to the control unit (a transfer period).

The drive circuit applies the potential V1 to the readout electrode 21A and applies the potential V2 to the accumulation electrode 21B again after the readout operation is completed. This allows the carriers generated through the photoelectric conversion to be attracted to the accumulation electrode 21B and to be accumulated in the region of the photoelectric conversion layer 25 opposed to the accumulation electrode 21B (an accumulation period).

### (Acquisition of Blue Color Signal and Red Color Signal by Photoelectric Conversion Regions 32B and 32R)

Thereafter, of the light transmitted through the photoelectric converter 20, the blue light is absorbed in the photoelectric conversion region 32B, and the red light is absorbed in the photoelectric conversion region 32R sequentially, followed by photoelectric conversion. In the photoelectric conversion region 32B, electrons corresponding to the blue light that has entered are accumulated in the n region of the photoelectric conversion region 32B, and the accumulated electrons are transferred to the floating diffusion FD2 through the transfer transistor Tr2. Similarly, in the photoelectric conversion region 32R, electrons corresponding to the red light that has entered are accumulated in the n region of the photoelectric conversion region 32R, and the accumulated electrons are transferred to the floating diffusion FD3 through the transfer transistor Tr3.

### (1-4. Workings and Effects)

According to the imaging element 10 of the present embodiment, the protective layer 24 is provided between the oxide semiconductor layer 23 and the photoelectric conversion layer 25 in the photoelectric converter 20. The protective layer 24 includes the first layer 24A and the second layer 24B that include oxygen (O), the element X, and the element Y as a common element. The first layer 24A and the second layer 24B are sequentially stacked from the side of the oxide semiconductor layer 23. The first layer 24A and the second layer 24B satisfy Rₓ₁ > Rₓ₂ ≥ 0 and 0 ≤ R_{y1} < R_{y2} in a case where the composition ratio of the element X and the element Y is defined as the number of atoms of each of the element X and the element Y divided by the total number of atoms of the element X and the element Y, and where the composition ratio of the element X included in the first layer 24A is referred to as Rₓ₁, the composition ratio of the element Y included in the first layer 24A is referred to as R_{y1}, the composition ratio of the element X included in the second layer 24B is referred to as Rₓ₂, and the composition ratio of the element Y included in the second layer 24B is referred to as R_{y2}. This reduces defects in the oxide semiconductor layer without hindering transport of carriers from the photoelectric conversion layer 25. This will be described below.

In recent years, in a CCD image sensor or a CMOS image sensor, because the number of photons entering a unit pixel is reduced as a pixel size is reduced, the sensitivity is lowered, and S/N is lowered. Further, in the image sensor that is widely used at present, a red pixel, a green pixel, and a blue pixel in which the red, green, and blue primary color filters are respectively located are arranged in a Bayer pattern. However, in each color pixel, light other than the corresponding color light (for example, green light and blue light in the red pixel) is not transmitted through the color filter and is not used for photoelectric conversion. This is a loss in terms of sensitivity. In addition, there arises a problem of false color caused by performing interpolation processing between pixels to produce a color signal.

As a method for solving these problems, there is known an image sensor in which three layers of photoelectric conversion layers are stacked in a vertical direction to obtain photoelectric conversion signals of three colors in one pixel. As such a structure in which three-color photoelectric conversion layers are stacked in one pixel, for example, an image sensor has been proposed in which a photoelectric converter that detects green light and generates signal charges corresponding to the green light is provided above a silicon substrate, and blue light and red light are detected by two PDs stacked in the silicon substrate. Further, in a structure in which one layer of an organic photoelectric conversion film is provided above a silicon substrate and two inorganic photoelectric converters are provided in the silicon substrate, there have been proposed a structure including a back side illumination type structure in which a circuit-forming surface is formed on a reverse side of a light-receiving surface and a structure provided with an oxide semiconductor film and an insulating film that accumulate and transfer electric charges directly under the photoelectric conversion film and including a plurality of electrodes (a charge readout electrode and a charge accumulation electrode) as the lower electrode.

In the former case, when the organic photoelectric conversion layer is formed as the back side illumination type, because no circuit, wiring, or the like is formed between the inorganic photoelectric converter and the organic photoelectric converter, it is possible to shorten the distance between the inorganic photoelectric converter and the organic photoelectric converter in the same pixel. It is therefore possible to reduce the F value dependency of each color, and it is possible to reduce the fluctuation of the sensitivity between the colors. In the latter case, because the charge accumulation electrode is located to oppose the photoelectric conversion layer with the insulating layer disposed therebetween, it is possible to store the electric charge generated by the photoelectric conversion in the oxide semiconductor film. This makes it possible to completely deplete a charge accumulation section at a start of the exposure and erase the charge. Consequently, it is possible to suppress occurrence of phenomena such as an increase in kTC noise, deterioration in random noise, and a decrease in imaging quality.

Incidentally, as described above, in the image sensor in which the insulating film and the oxide semiconductor film are stacked between the plurality of electrodes and the photoelectric conversion layer, the occurrence of defects due to the desorption of oxygen from the oxide semiconductor layer is a problem. As described above, a structure has been proposed that prevents the desorption of oxygen from the oxide semiconductor layer by stacking an oxide film on the oxide semiconductor film. Although it is possible to reduce the defects of the oxide semiconductor film by terminating with an element such as hydrogen, desorption easily occurs in a process after the oxide film formation. In addition, there are restrictions on the conduction band energy and the film thickness of the oxide film so as not to hinder transport of carriers from the photoelectric conversion layer. It is therefore difficult to sufficiently reduce the desorption of the element terminating the defects simply by forming the oxide film.

In contrast, in the present embodiment, the protective layer 24 including the first layer 24A and the second layer 24B is provided between the oxide semiconductor layer 23 and the photoelectric conversion layer 25. The first layer 24A and the second layer 24B include oxygen (O), the element X, and the element Y as a common element. The first layer 24A and the second layer 24B satisfy Rₓ₁ > Rₓ₂ ≥ 0 and 0 ≤ R_{y1} < R_{y2} in a case where the composition ratio of the element X and the element Y is defined as the number of atoms of each of the element X and the element Y divided by the total number of atoms of the element X and the element Y, and where the composition ratio of the element X included in the first layer 24A is referred to as Rₓ₁, the composition ratio of the element Y included in the first layer 24A is referred to as R_{y1}, the composition ratio of the element X included in the second layer 24B is referred to as Rₓ₂, and the composition ratio of the element Y included in the second layer 24B is referred to as R_{y2}. As a result, the interface defects of the oxide semiconductor layer 23 are terminated without hindering the transport of the carriers from the photoelectric conversion layer 25, and the desorption of the terminated element is reduced.

As described above, the imaging element 10 according to the present embodiment makes it possible to improve the image quality.

Next, a second embodiment and modification examples (Modification Examples 1 to 6) of the present disclosure will be described. Hereinafter, components similar to those in the above-described embodiment are denoted by the same reference numerals, and description thereof will be omitted as appropriate.

### <2. Second Embodiment>

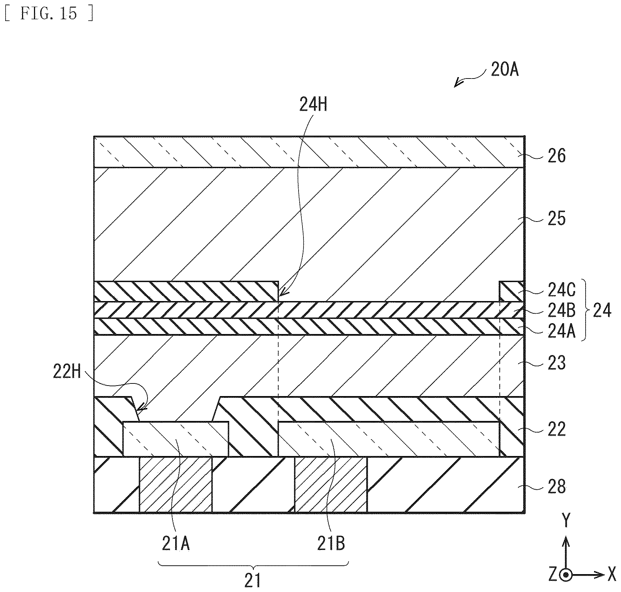

FIG. 15 illustrates a cross-sectional configuration of a main part (a photoelectric converter 20A) of an imaging element according to a second embodiment of the present disclosure. Similarly to the photoelectric converter 20 of the first embodiment, the photoelectric converter 20A constitutes, for example, one pixel (unit pixel P) repeatedly arranged in an array in the pixel section 1A of an imaging device (for example, the imaging device 1, see FIG. 28) such as a CMOS image sensor to be used, for example, in an electronic apparatus such as a digital still camera or a video camera, as the imaging element 10 together with the two photoelectric conversion regions 32B and 32R.

The photoelectric converter 20A of the present embodiment includes the lower electrode 21 including the readout electrode 21A and the accumulation electrode 21B, the insulating layer 22, the oxide semiconductor layer 23, the protective layer 24, the photoelectric conversion layer 25, and the upper electrode 26 stacked in this order. The protective layer 24 includes a plurality of layers. For example, the first layer 24A, the second layer 24B, and a third layer 24C are stacked in this order from the side of the oxide semiconductor layer 23. One of the layers, for example, the third layer 24C has an opening 24H at a position opposed to the accumulation electrode 21B. The readout electrode 21A corresponds to a specific example of a "second electrode" of the present disclosure, and the accumulation electrode 21B corresponds to a specific example of a "first electrode" of the present disclosure. Further, the first layer 24A corresponds to a specific example of a "first layer" of the present disclosure, the second layer 24B corresponds to a specific example of a "second layer" of the present disclosure, and the third layer 24C corresponds to a specific example of a "third layer" of the present disclosure.

### (2-1. Configuration of Photoelectric Converter)

In the photoelectric converter 20A, the oxide semiconductor layer 23, the protective layer 24 including an inorganic material, and the photoelectric conversion layer 25 including an organic material are stacked in this order from a side of the lower electrode 21 between the lower electrode 21 and the upper electrode 26 that are disposed to oppose each other. The protective layer 24 includes, as described above, the first layer 24A, the second layer 24B, and the third layer 24C stacked in this order. One of the layers, for example, the third layer 24C has the opening 24H at a position opposed to the accumulation electrode 21B. The photoelectric converter 20A further includes the insulating layer 22 between the lower electrode 21 and the oxide semiconductor layer 23.

The lower electrode 21, the insulating layer 22, the oxide semiconductor layer 23, the photoelectric conversion layer 25, and the upper electrode 26 that constitute the photoelectric converter 20A have the configuration similar to that of the photoelectric converter 20 in the first embodiment, and therefore will not be described in the present embodiment.

The protective layer 24 prevents oxygen from being desorbed from the oxide semiconductor layer 23. The protective layer 24 has the first layer 24A, the second layer 24B, and the third layer 24C that are sequentially stacked from the side of the oxide semiconductor layer 23. The first layer 24A and the second layer 23B have composition ratios different from each other similarly to the first embodiment. Specifically, the first layer 24A and the second layer 24B include oxygen (O), the element X, and the element Y as a common element and satisfy Rₓ₁ > Rₓ₂ ≥ 0 and 0 ≤ R_{y1} < R_{y2} in a case where the composition ratio of the element X and the element Y is defined as the number of atoms of each of the element X and the element Y divided by the total number of atoms of the element X and the element Y, and where the composition ratio of the element X included in the first layer is referred to as Rₓ₁, the composition ratio of the element Y included in the first layer is referred to as R_{y1}, the composition ratio of the element X included in the second layer is referred to as Rₓ₂, and the composition ratio of the element Y included in the second layer is referred to as R_{y2}.

A difference between the composition ratio Rₓ₁ of the element X in the first layer 24A and the composition ratio Rₓ₂ of the element X in the second layer 24B is preferably 0.1 or more. The film density of the first layer 24A is preferably smaller than the film density of the second layer 24B. It is preferable that the first layer 24A have a film thickness of 1 atomic layer or more and 5 nm or less, the second layer 24B have a film thickness of 1 nm or more and 10 nm or less, and the total film thickness of the first layer 24A and the second layer 24B be less than 10 nm. It is preferable that the first layer 24A have a film density of 3.0 g/cm³ or less, and the second layer 24B have a film density of 2.5 g/cm³ or more.

In a case where it is defined that the further it is from the vacuum level, the higher (the deeper) the energy on the assumption that the vacuum level is the zero reference, and where the energy level at the lowermost end of the conduction band of the photoelectric conversion layer 25 is referred to as Eco, the energy level at the lowermost end of the conduction band of the oxide semiconductor layer 23 is referred to as Ecc, the energy level at the lowermost end of the conduction band of the first layer 24A is referred to as Ec_{A}, and the energy level at the lowermost end of the conduction band of the second layer 24B is referred to as Ec_{B}, the first layer 24A and the second layer 23B preferably satisfy Ec_{O} ≤ Ec_{B} ≤ Ec_{A} ≤ Ec_{C}.

Similarly to the first embodiment, the first layer 24A and the second layer 23B may include a metal oxide including at least one element out of, for example, tantalum (Ta), titanium (Ti), vanadium (V), niobium (Nb), tungsten (W), zirconium (Zr), hafnium (Hf), scandium (Sc), yttrium (Y), lanthanum (La), gallium (Ga), and magnesium (Mg). Specifically, examples of the constituent material of the protective layer 24 include tantalum oxide (Ta₂O₅), titanium oxide (TiO₂), vanadium oxide (V₂O₅), niobium oxide (Nb₂O₅), tantalum oxide (W₂O₃), zirconium oxide (ZrO₂), hafnium oxide (HfO₂), scandium oxide (Sc₂O₃), yttrium oxide (Y₂O₃), lanthanum oxide (La₂O₃), gallium oxide (Ga₂O₃), and magnesium oxide (MgO).

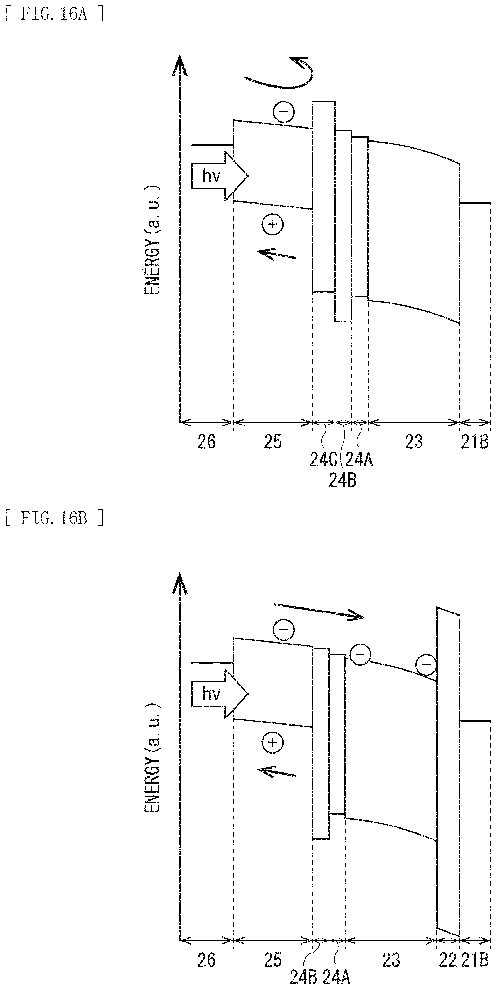

FIG. 16A illustrates an example of energy levels of the insulating layer 22, the oxide semiconductor layer 23, the protective layer 24 (the first layer 24A, the second layer 24B, and the third layer 24C), the photoelectric conversion layer 25, and the upper electrode 26 stacked above the readout electrode 21A. FIG. 16B illustrates an example of energy levels of the insulating layer 22, the oxide semiconductor layer 23, the protective layer 24 (the first layer 24A, the second layer 24B, and the third layer 24C), the photoelectric conversion layer 25, and the upper electrode 26 stacked above the accumulation electrode 21B.

The third layer 24C is not particularly limited in terms of the energy level, film density, and film thickness at a lowermost end of a conduction band, except that it has the opening 24H at the position opposed to the accumulation electrode 21B. For example, in a case where it is defined that the further it is from the vacuum level, the higher (the deeper) the energy on the assumption that the vacuum level is the zero reference, and where the energy level at the lowermost end of the conduction band of the photoelectric conversion layer 25 is referred to as Eco, and the energy level at the lowermost end of the conduction band of the third layer 24C is referred to as Ec_{D}, the energy level Ec_{D} may be lower than the energy level Eco as illustrated in FIG. 16A. This makes it possible to efficiently accumulate the carriers (electrons) generated in the photoelectric conversion layer 25 in the oxide semiconductor layer 23 above the accumulation electrode 21B, and to prevent backflow of signal charges from the side of the oxide semiconductor layer 23 to the photoelectric conversion layer 25.

It is to be noted that it is preferable that the total film thickness of the first layer 24A and the second layer 24B in the opening 24H is 1 nm or more and less than 10 nm, and the total film thickness of the first layer 24A, the second layer 24B, and the third layer 24C is 1 nm or more and less than 100 nm in view of a strain of the layer stacked on the protective layer 24.

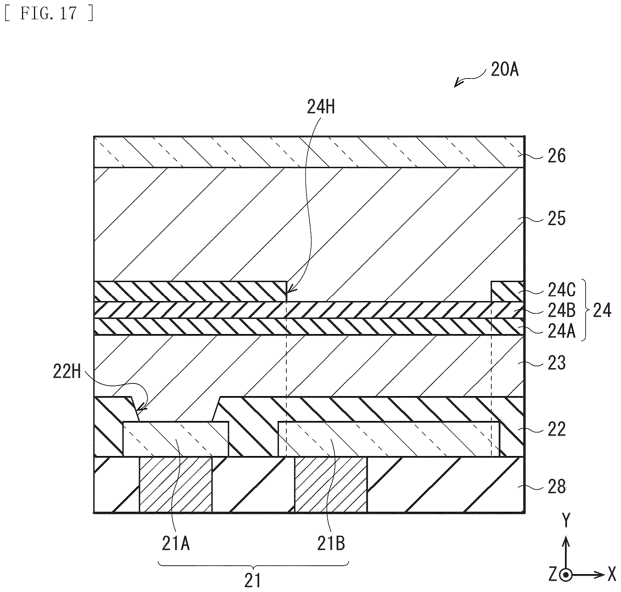

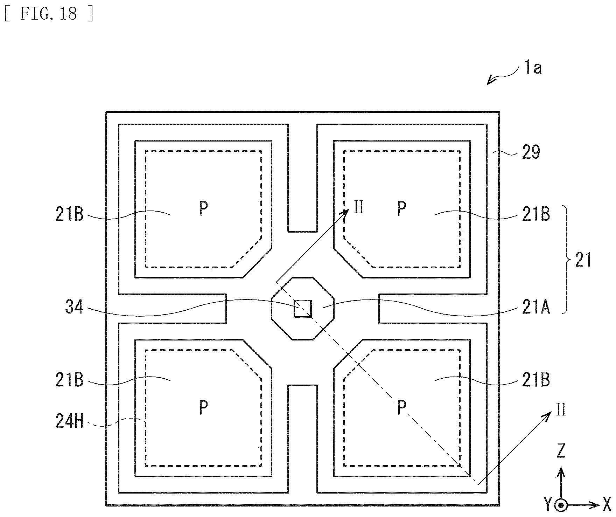

The opening 24H of the third layer 24C is preferably larger than half of the area of the accumulation electrode 21B. For example, although it is preferable that the side surface of the accumulation electrode 21B and the side surface of the opening 24H are substantially aligned with each other in a plan view as illustrated in FIG. 15, the opening 24H of the third layer 24C may be a size smaller than the accumulation electrode 21B as illustrated in FIGs. 17 and 18, for example. Specifically, the side surface of the opening 24H of the third layer 24C may be formed to be inward of the sides of the accumulation electrode 21B by, for example, 10 nm.

The third layer 24C may include SiOₓ, SiON, SiOC, or AlOₓ in addition to the metal oxide listed as the constituent material of the first layer 24A and the second layer 23B.

### (2-1. Workings and Effects)

In the photoelectric converter 20A of the present embodiment, the third layer 24C having the opening 24H at a position opposed to the accumulation electrode 21B is further stacked on the first layer 24A and the second layer 24B, which are sequentially stacked from the side of the oxide semiconductor layer 23, between the oxide semiconductor layer 23 and the photoelectric conversion layer 25. This makes it possible to further reduce defects in the oxide semiconductor layer without hindering the transport of the carriers from the photoelectric conversion layer 25. This makes it possible to further improve the image quality.

### <3. Modification Examples>

### (3-1. Modification Example 1)

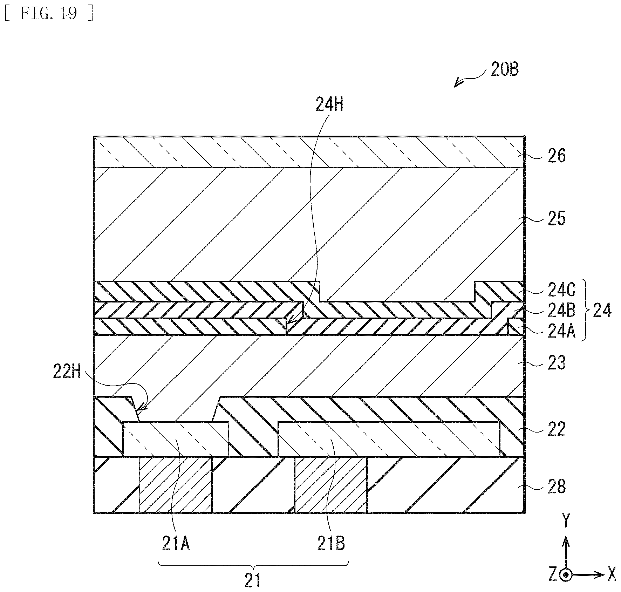

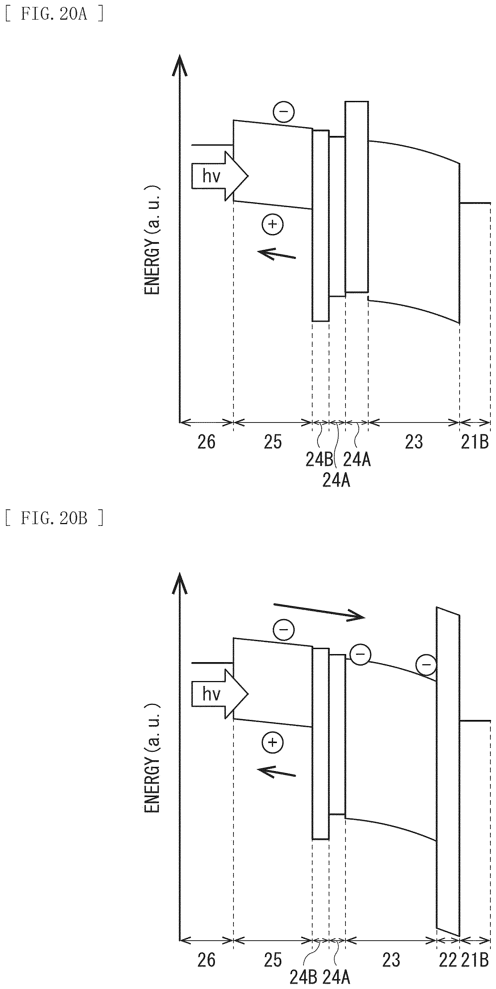

FIG. 19 schematically illustrates a cross-sectional configuration of a main part (a photoelectric converter 20B) of an imaging element according to Modification Example 1 of the present disclosure. FIG. 20A illustrates an example of energy levels of the insulating layer 22, the oxide semiconductor layer 23, the protective layer 24 (the first layer 24A, the second layer 24B, and the third layer 24C), the photoelectric conversion layer 25, and the upper electrode 26 stacked above the readout electrode 21A. FIG. 20B illustrates an example of energy levels of the insulating layer 22, the oxide semiconductor layer 23, the protective layer 24 (the first layer 24A, the second layer 24B, and the third layer 24C), the photoelectric conversion layer 25, and the upper electrode 26 stacked above the accumulation electrode 21B. The photoelectric converter 20B of the present modification example differs from the second embodiment in that the third layer 24C in the second embodiment is provided between the oxide semiconductor layer 23 and the first layer 24A.

The position of the third layer 24C in the protective layer 24 is not limited to a particular position. The third layer 24C may be formed on the second layer 24B as in the photoelectric converter 20A of the second embodiment, or may be provided between the oxide semiconductor layer 23 and the first layer 24A as in the present modification example. Alternatively, the third layer 24C may be provided between the first layer 24A and the second layer 24B. In any configuration, it is possible to achieve the effects similar to those of the second embodiment.

### (3-2. Modification Example 2)

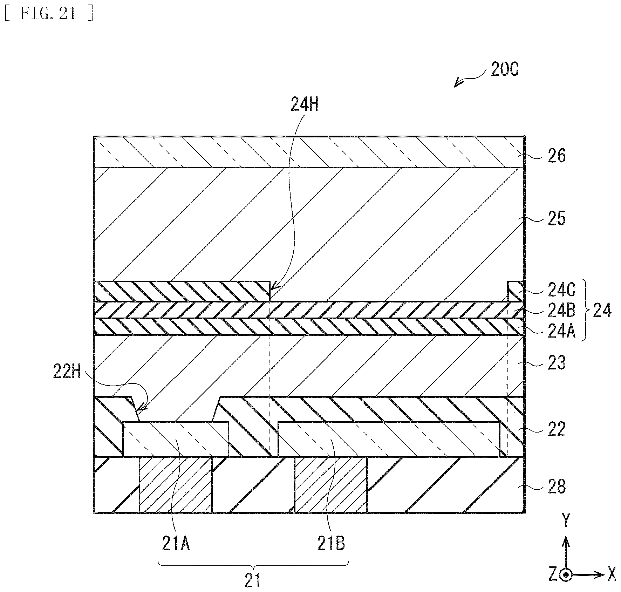

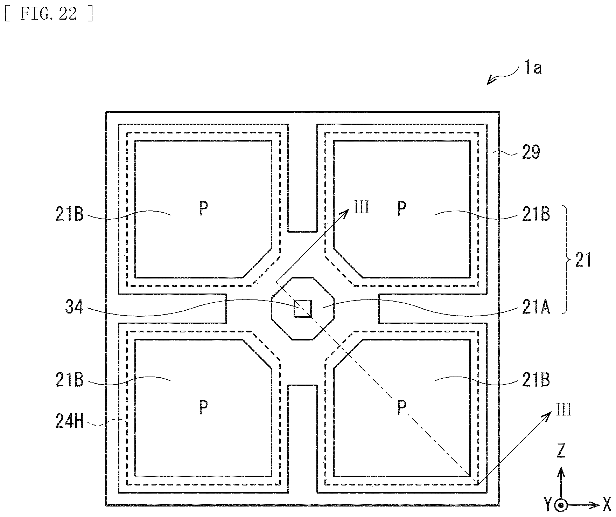

FIG. 21 schematically illustrates a cross-sectional configuration of a main part (a photoelectric converter 20C) of an imaging element according to Modification Example 2 of the present disclosure. FIG. 22 schematically illustrates an example of a pixel configuration of the imaging device 1 including the photoelectric converter 20C illustrated in FIG. 21. FIG. 21 illustrates a cross-section taken along line III-III of FIG. 22. In the second embodiment, the example has been illustrated in which the side surface of the opening 24H of the third layer 24C is substantially aligned with the side surface of the accumulation electrode 21B in plan view, or is located inward of the sides of the accumulation electrode 21B; however, this is not limitative.

The opening 24H of the third layer 24C may be a size larger than the accumulation electrode 21B. For example, 10 nm < L_ov < L_f and 10 nm < L_ov < L_s may be satisfied in a case where the minimum distance between an edge of the accumulation electrode 21B and an edge of a floating diffusion FD is referred to as L_f, the minimum distance between the edge of the accumulation electrode 21B and an edge of the shield electrode 29 is referred to as L_s, and the minimum distance between the edge of the accumulation electrode 21B and an edge of the opening 24H is referred to as L_ov.

### (3-3. Modification Example 3)

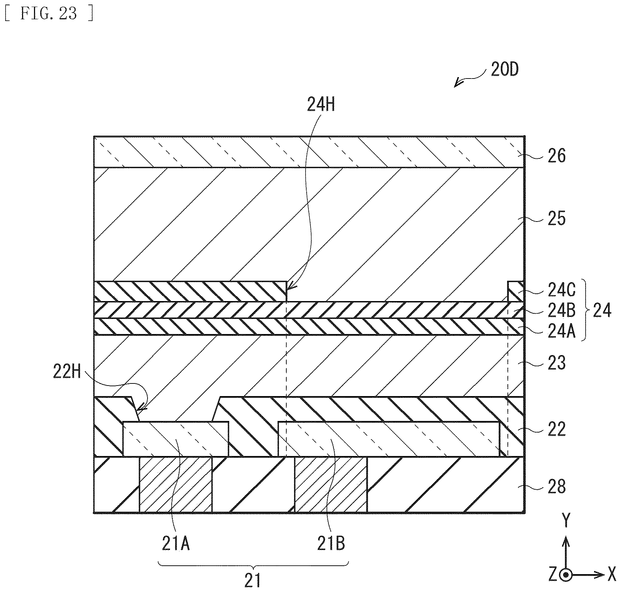

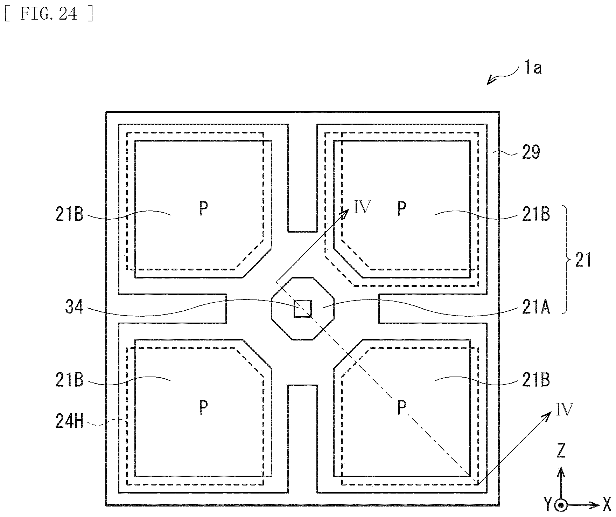

FIG. 23 schematically illustrates a cross-sectional configuration of a main part (a photoelectric converter 20D) of an imaging element according to Modification Example 3 of the present disclosure. FIG. 24 schematically illustrates an example of a pixel configuration of the imaging device 1 including the photoelectric converter 20D illustrated in FIG. 23. FIG. 23 illustrates a cross-section taken along line IV-IV of FIG. 24. In the second embodiment, the example has been illustrated in which the side surface of the opening 24H of the third layer 24C is substantially aligned with the side surface of the accumulation electrode 21B in plan view, or is located inward of the sides of the accumulation electrode 21B; however, this is not limitative.

The opening 24H of the third layer 24C may have a layout including no section opposed to the shield electrode 29 with the oxide semiconductor layer 23 interposed therebetween, and including sections opposed to the accumulation electrode 21B with the oxide semiconductor layer 23 interposed therebetween. For example, L_d ≥ L_f + 10 nm may be satisfied in a case where the minimum distance between the edge of the accumulation electrode 21B and the edge of the floating diffusion FD is referred to as L_f, and the minimum distance between the edge of the floating diffusion FD and the edge of the opening 24H is referred to as L_d.

### (3-4. Modification Example 4)

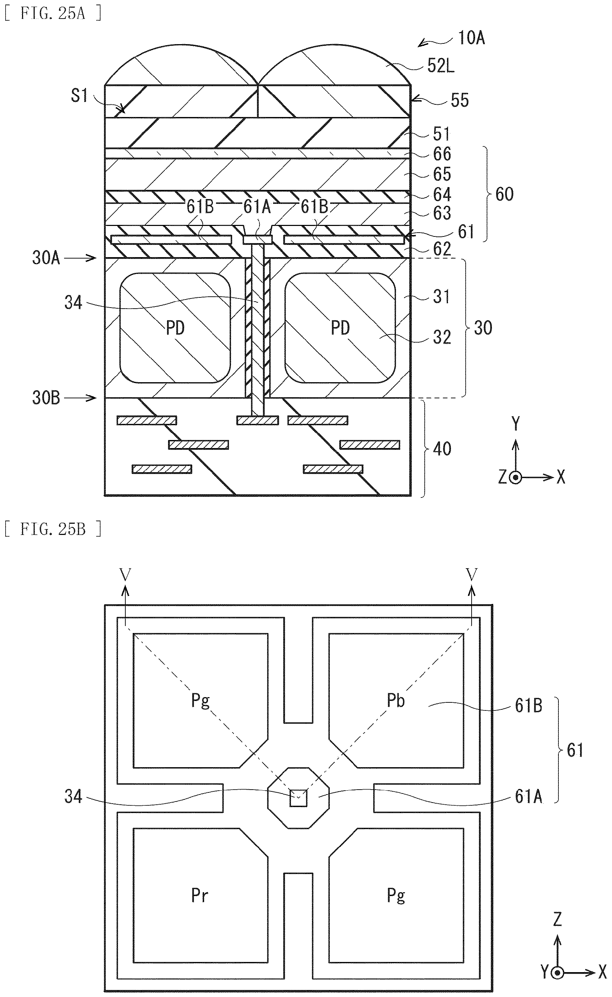

FIG. 25A schematically illustrates a cross-sectional configuration of an imaging element 10A according to Modification Example 4 of the present disclosure. FIG. 25B schematically illustrates an example of a planar configuration of the imaging element 10A illustrated in FIG. 25A. FIG. 25A illustrates a cross-section taken along line V-V illustrated in FIG. 25B. The imaging element 10A is, for example, a stacked-type imaging element in which a photoelectric conversion region 32 and a photoelectric converter 60 are stacked. In the pixel section 1A of the imaging device (for example, the imaging device 1) including the imaging element 10A, the pixel unit 1a including four pixels arranged in, for example, two rows × two columns as illustrated in FIG. 25B for example serves as a repeating unit, and is repeatedly arranged in an array including a row direction and a column direction.

The imaging element 10A of the present modification is provided with color filters 55 above the photoelectric converter 60 (the light incident side S1) for the respective unit pixels P. The color filters 55 selectively transmit the red light (R), the green light (G), and the blue light (B). Specifically, in the pixel unit 1a including four pixels arranged in two rows × two columns, two color filters that selectively transmit the green light (G) are disposed along a diagonal line, and one color filter that selectively transmits the red light (R) and one color filter that selectively transmits the blue light (B) are disposed along an orthogonal diagonal line. The unit pixels (Pr, Pg, and Pb) provided with the respective color filters are configured to detect the corresponding color light beams, for example, in the photoelectric converter 60. That is, the pixels (Pr, Pg, and Pb) each detecting the red light (R), the green light (G), and the blue light (B) are arranged in a Bayer pattern in the pixel section 1A.

The photoelectric converter 60 absorbs light corresponding to a portion or all of the wavelengths in the visible light region of 400 nm or more and less than 750 nm, for example, to generate excitons (electron-hole pairs), and includes a lower electrode 61, an insulating layer (an interlayer insulating layer 62), an oxide semiconductor layer 63, a protective layer 64, a photoelectric conversion layer 65, and an upper electrode 66 stacked in this order. The lower electrode 61, the interlayer insulating layer 62, the oxide semiconductor layer 63, the protective layer 64, the photoelectric conversion layer 65, and the upper electrode 66 each have the configuration similar to that of the lower electrode 21, the insulating layer 22, the oxide semiconductor layer 23, the protective layer 24, the photoelectric conversion layer 25, and the upper electrode 26 of the photoelectric converter 20 and the like in the first and second embodiments. The lower electrode 61 includes, for example, a readout electrode 61A and an accumulation electrode 61B that are independent of each other. The readout electrode 61A is shared by, for example, four pixels. It is to be noted that the oxide semiconductor layer 63 may be omitted.

The photoelectric conversion region 32 detects an infrared light region of 750 nm or more and 1300 nm or less, for example.

In the imaging element 10A, of the light beams transmitted through the color filters 55, the light beams (the red light (R), the green light (G), and the blue light (B)) in the visible light region are absorbed by the photoelectric converter 60 of the unit pixels (Pr, Pg, and Pb) provided with the respective color filters. Other light, for example, the light (the infrared light (IR)) in the infrared light region (for example, 750 nm or more and 1000 nm or less) is transmitted through the photoelectric converter 60. The infrared light (IR) transmitted through the photoelectric converter 60 is detected in the photoelectric conversion region 32 of each of the unit pixels Pr, Pg, and Pb. Each of the unit pixels Pr, Pg, and Pb generates a signal charge corresponding to the infrared light (IR). That is, it is possible for the imaging device 1 including the imaging element 10A to simultaneously generate both a visible light image and an infrared light image.

Further, it is possible for the imaging device 1 including the imaging element 10A to acquire the visible light image and the infrared light image at the same position in an XZ in-plane direction. This makes it possible to achieve higher integration in the XZ in-plane direction.

### (3-5. Modification Example 5)

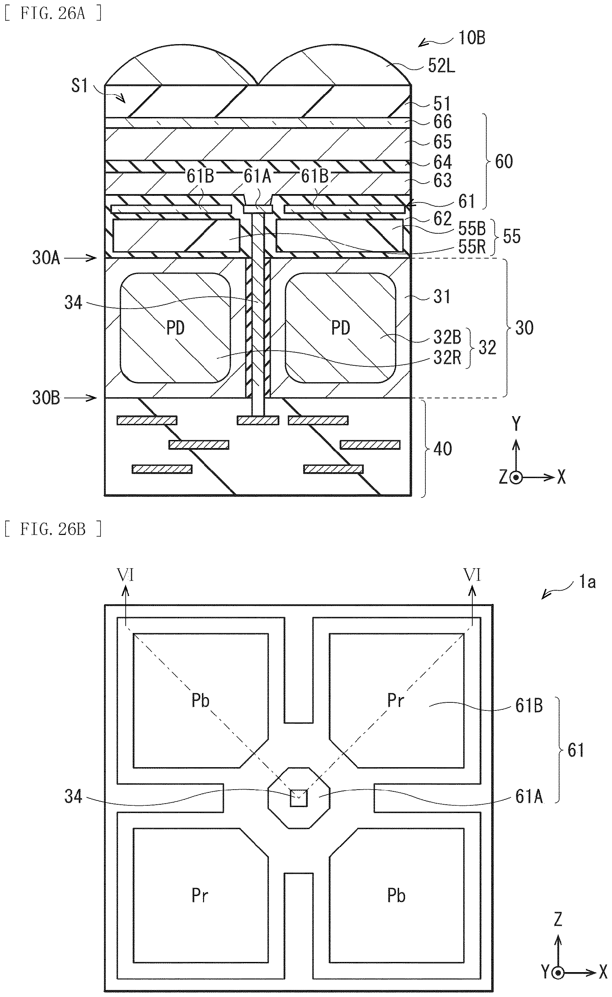

FIG. 26A schematically illustrates a cross-sectional configuration of an imaging element 10B according to Modification Example 5 of the present disclosure. FIG. 26B schematically illustrates an example of a planar configuration of the imaging element 10B illustrated in FIG. 26A. FIG. 26A illustrates a cross-section taken along line VI-VI illustrated in FIG. 26B. In Modification Example 4 above, the example has been illustrated in which the color filters 55 are provided above the photoelectric converter 60 (the light incident side S1), but the color filters 55 may be provided between the photoelectric conversion region 32 and the photoelectric converter 60, for example, as illustrated in 26A.

In the imaging element 10B, for example, the color filters 55 have a configuration in which a color filter (a color filter 55R) that selectively transmits at least the red light (R) and a color filter (a color filter 55B) that selectively transmits at least the blue light (B) are arranged diagonally to each other in the pixel unit 1a. The photoelectric converter 60 (the photoelectric conversion layer 65) is configured to selectively absorb light having a wavelength corresponding to, for example, the green light (G). Light having a wavelength corresponding to the red light (R) is selectively absorbed in the photoelectric conversion region 32R. Light having a wavelength corresponding to the blue light (B) is selectively absorbed in the photoelectric conversion region 32B. This makes it possible for the photoelectric converter 60 and the photoelectric conversion regions 32 (the photoelectric conversion regions 32R and 32B) respectively disposed below the color filters 55R and 55B to acquire signals corresponding to the red light (R), the green light (G), or the blue light (B). The imaging element 10B according to the present modification example enables the photoelectric converter of each of R, G, and B to have a larger area than that of the photoelectric conversion element having a typical Bayer arrangement. This makes it possible to improve the S/N ratio.

### (3-6. Modification Example 6)

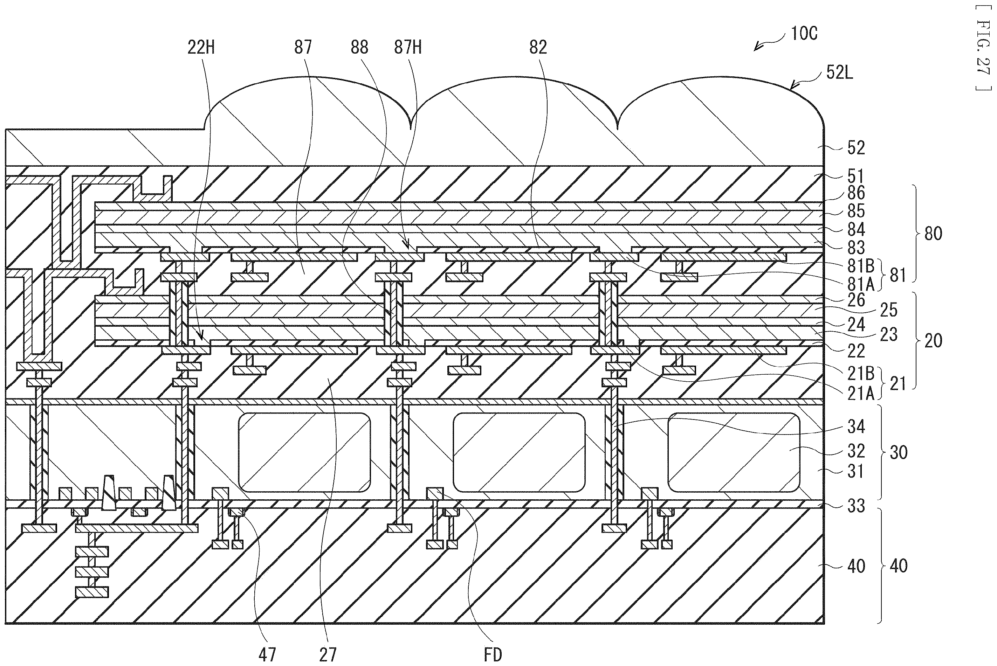

FIG. 27 schematically illustrates a cross-sectional configuration of an imaging element 10C according to Modification Example 6 of the present disclosure. In the imaging element 10C of the present modification example, two photoelectric converters 20 and 80 and one photoelectric conversion region 32 are vertically stacked.

The photoelectric converters 20 and 80 and the photoelectric conversion region 32 selectively detect light in wavelength ranges different from each other and perform photoelectric conversion. For example, the photoelectric converter 20 acquires a green (G) color signal. For example, the photoelectric converter 80 acquires a blue (B) color signal. For example, the photoelectric conversion region 32 acquires a red (R) color signal. This makes it possible for the imaging element 10C to acquire a plurality of kinds of color signals in one pixel without using a color filter.

The photoelectric converter 80 is stacked above, for example, the photoelectric converter 20 and has a configuration similar to that of the photoelectric converter 20. Specifically, in the photoelectric converter 80, a lower electrode 81, an insulating layer 82, an oxide semiconductor layer 83, a protective layer 84, a photoelectric conversion layer 85, and an upper electrode 86 are stacked in this order. Similarly to the photoelectric converter 20, the lower electrode 81 includes a plurality of electrodes (for example, a readout electrode 81A and an accumulation electrode 81B), and is electrically separated by the insulating layer 82. An interlayer insulating layer 87 is provided between the photoelectric converter 80 and the photoelectric converter 20.

The readout electrode 81A is coupled to a through-electrode 88 that extends through the interlayer insulating layer 87 and the photoelectric converter 20. The through-electrode 88 is electrically coupled to the readout electrode 21A of the photoelectric converter 20. Further, the readout electrode 81A is electrically coupled to the floating diffusion FD provided in the semiconductor substrate 30 via the through-electrodes 34 and 88. It is therefore possible for the readout electrode 81A to temporarily accumulate carriers generated in the photoelectric conversion layer 85. Further, the readout electrode 81Ais electrically coupled to, for example, an amplifier transistor AMP provided in the semiconductor substrate 30 via the through-electrodes 34 and 88.

### <4. Application Examples>

### (Application Example 1)

FIG. 28 illustrates an example of an overall configuration of the imaging device (the imaging device 1) including the imaging element (for example, the imaging element 10) illustrated in, for example, FIG. 1.

The imaging device 1 is, for example, a CMOS image sensor. The imaging device 1 takes in incident light (image light) from a subject via an optical lens system (not illustrated), and converts the amount of incident light formed as an image on an imaging surface into electric signals in units of pixels to output the electric signals as pixel signals. The imaging device 1 has the pixel section 1A that serves as an imaging area on the semiconductor substrate 30, and has, for example, the vertical drive circuit 111, the column signal processing circuit 112, the horizontal drive circuit 113, the output circuit 114, the control circuit 115, and the input/output terminal 116 in the peripheral region of the pixel section 1A.

The pixel section 1A includes, for example, the plurality of unit pixels P two-dimensionally arranged in a matrix. To the unit pixels P, for example, a pixel driving line Lread (specifically, a row selection line and a reset control line) is wired for each pixel row, and a vertical signal line Lsig is wired for each pixel column. The pixel driving line Lread transmits a driving signal for reading out a signal from a pixel. One end of the pixel driving line Lread is coupled to an output terminal corresponding to each row of the vertical drive circuit 111.

The vertical drive circuit 111 is a pixel driver that includes a shift register, an address decoder, or the like and drives each of the unit pixels P of the pixel section 1A on a row-by-row basis, for example. A signal outputted from each unit pixel P of the pixel row that is selected and scanned by the vertical drive circuit 111 is supplied to the column signal processing circuit 112 through each of the vertical signal lines Lsig. The column signal processing circuit 112 includes an amplifier, a horizontal selection switch, and the like provided for each vertical signal line Lsig.

The horizontal drive circuit 113 includes a shift register, an address decoder, or the like, and sequentially drives the horizontal selection switches of the column signal processing circuit 112 while scanning them. Through the selection scanning by the horizontal drive circuit 113, the signals of the pixels transmitted through the respective vertical signal lines Lsig are sequentially outputted to a horizontal signal line 121, and are transmitted to the outside of the semiconductor substrate 30 through the horizontal signal line 121.

The output circuit 114 performs signal processing on signals sequentially supplied from each of the column signal processing circuits 112 via the horizontal signal line 121, and outputs the signals. For example, the output circuit 114 may perform only buffering, or may perform black level adjustment, column variation correction, various kinds of digital signal processing, and the like.

The circuit sections including the vertical drive circuit 111, the column signal processing circuit 112, the horizontal drive circuit 113, the horizontal signal line 121, and the output circuit 114 may be formed directly on the semiconductor substrate 30 or may be disposed in an external control IC. Further, the circuit sections may be formed on another substrate coupled by a cable or the like.

The control circuit 115 receives a clock supplied from the outside of the semiconductor substrate 30, data that commands an operation mode, and the like, and also outputs data such as internal information regarding the imaging device 1. The control circuit 115 further includes a timing generator that generates various kinds of timing signals, and controls driving of the peripheral circuits such as the vertical drive circuit 111, the column signal processing circuit 112, and the horizontal drive circuit 113 on the basis of the various kinds of timing signals generated by the timing generator.

The input/output terminal 116 exchanges signals with the outside.

### (Application Example 2)

In addition, the above-described imaging device 1 is applicable, for example, to various kinds of electronic apparatuses including an imaging system such as a digital still camera or a digital video camera, a mobile phone having an imaging function, or other devices having an imaging function.

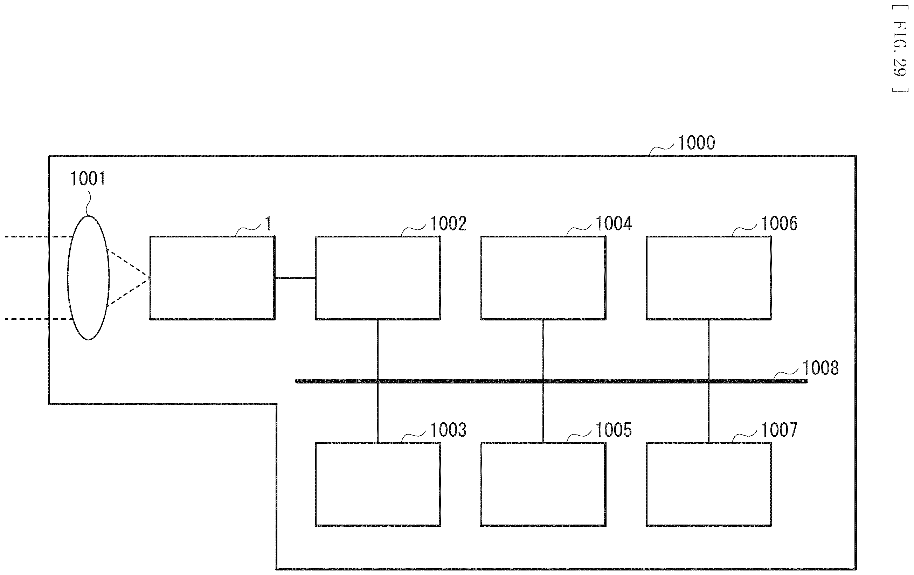

FIG. 29 is a block diagram illustrating an example of a configuration of an electronic apparatus 1000.

As illustrated in FIG. 29, the electronic apparatus 1000 includes an optical system 1001, the imaging device 1, and a DSP (Digital Signal Processor) 1002. The electronic apparatus 1000 includes the DSP1002, a memory 1003, a display device 1004, a recording device 1005, an operating system 1006, and a power supply system 1007 that are coupled to each other through a bus 1008. The configuration makes it possible to capture still images and moving images.

The optical system 1001 includes one or a plurality of lenses, and captures incident light (image light) from a subject and forms an image on an imaging surface of the imaging device 1.

The above-described imaging device 1 is applied as the imaging device 1. The imaging device 1 converts the amount of incident light formed as an image on the imaging surface by the optical system 1001 into electric signals in units of pixels, and supplies the electric signals to the DSP 1002 as pixel signals.

The DSP 1002 performs various kinds of signal processing on the signals from the imaging device 1 to acquire an image, and causes the memory 1003 to temporarily store data on the image. The data on the image stored in the memory 1003 is recorded in the recording device 1005 or supplied to the display device 1004 to display the image. Further, the operating system 1006 receives various kinds of operations by a user, and supplies operation signals to the respective blocks of the electronic apparatus 1000. The power supply system 1007 supplies electric power necessary to drive each block of the electronic apparatus 1000.

### (Application Example 3)

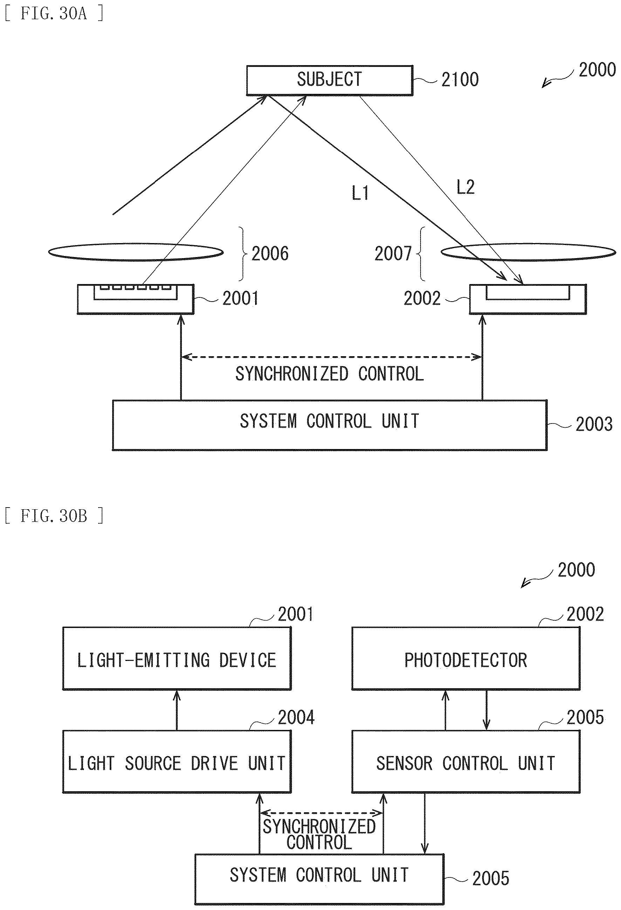

FIG. 30A schematically illustrates an example of an overall configuration of a photodetection system 2000 including the imaging device 1. FIG. 30B illustrates an example of a circuit configuration of the photodetection system 2000. The photodetection system 2000 includes a light-emitting device 2001 that serves as a light source section that emits infrared light L2, and a photodetector 2002 that serves as a light receiving section including a photoelectric conversion element. It is possible to use the above-described imaging device 1 as the photodetector 2002. The photodetection system 2000 may further include a system control unit 2003, a light source drive unit 2004, a sensor control unit 2005, a light source side optical system 2006, and a camera side optical system 2007.

It is possible for the photodetector 2002 to detect light L1 and light L2. The light L1 is light in which environment light from the outside is reflected by a subject (an object to be measured) 2100 (FIG. 30A). The light L2 is light reflected by the subject 2100 after having been emitted by the light-emitting device 2001. The light L1 is, for example, visible light, and the light L2 is, for example, infrared light. The light L1 is detectable by the photoelectric converter in the photodetector 2002, and the light L2 is detectable by the photoelectric conversion region in the photodetector 2002. It is possible to acquire image information regarding the subject 2100 from the light L1 and to acquire information regarding a distance between the subject 2100 and the photodetection system 2000 from the light L2. The photodetection system 2000 is mountable on, for example, an electronic apparatus such as a smartphone or a moving object such as a car. The light-emitting device 2001 may include, for example, a semiconductor laser, a surface-emitting semiconductor laser, or a vertical-cavity surface-emitting laser (VCSEL). The light L2 emitted from the light-emitting device 2001 may be detected by the photodetector 2002 using, for example, an iTOF method; however, this is not limitative. In the iTOF method, it is possible for the photoelectric converter to measure the distance to the subject 2100 by, for example, time-of-flight of light (Time-of-Flight; TOF). As a method for the photodetector 2002 to detect the light L2 emitted from the light-emitting device 2001, for example, a structured light system or a stereo vision system may be adopted. For example, in the structured light system, it is possible to measure the distance between the photodetection system 2000 and the subject 2100 by projecting light of a predetermined pattern onto the subject 2100 and analyzing a distortion degree of the pattern. Further, in the stereo vision system, it is possible to measure the distance between the photodetection system 2000 and the subject by, for example, acquiring two or more images of the subject 2100 viewed from two or more different viewpoints using two or more cameras. It is to be noted that it is possible for the system control unit 2003 to synchronously control the light-emitting device 2001 and the photodetector 2002.

### <5. Practical Application Examples>

### (Example of Practical Application to Endoscopic Surgery System)

A technique of the present disclosure (the present technology) is applicable to various products. For example, the technique of the present disclosure may be applied to an endoscopic surgery system.

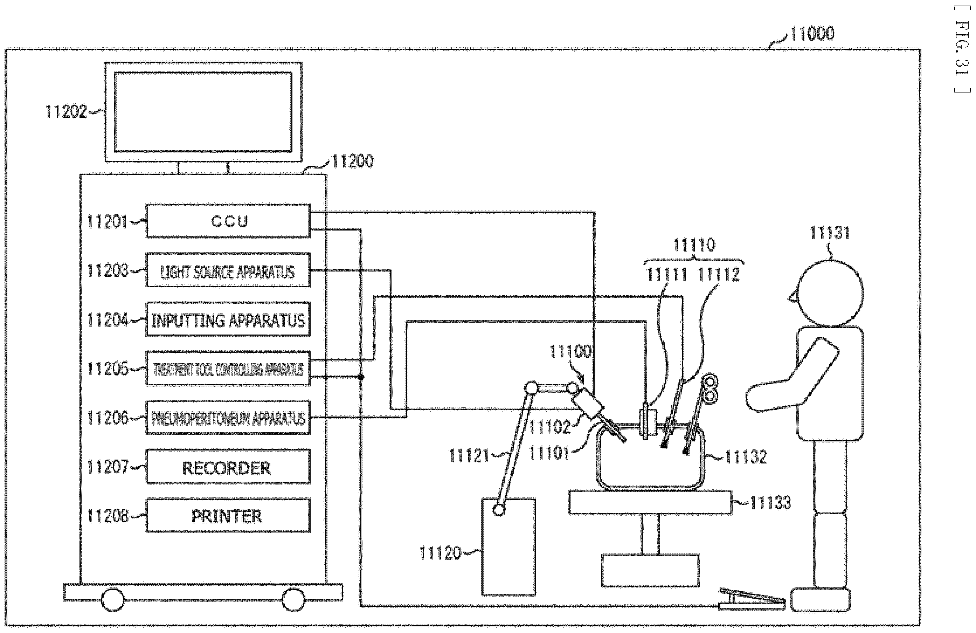

FIG. 31 is a view depicting an example of a schematic configuration of an endoscopic surgery system to which the technology according to an embodiment of the present disclosure (present technology) can be applied.

In FIG. 31, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photoelectrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

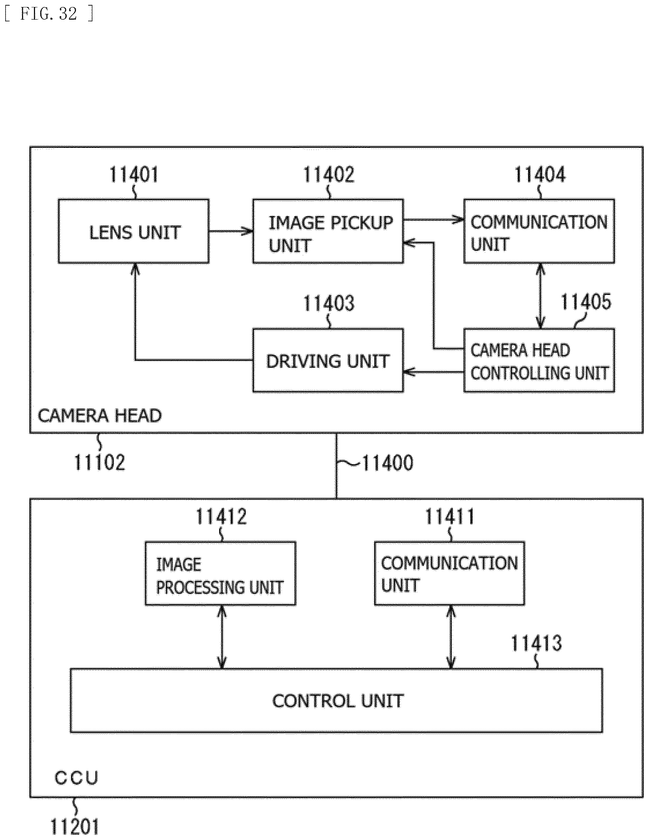

FIG. 32 is a block diagram depicting an example of a functional configuration of the camera head 11102 and the CCU 11201 depicted in FIG. 31.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

The description has been given above of an example of the endoscopic surgery system, to which the technique according to the present disclosure is applicable. The technique according to the present disclosure is applicable to the image pickup unit 11402 out of the configurations described above. Applying the technique according to the present disclosure to the image pickup unit 11402 makes it possible to improve detection accuracy.

It is to be noted that although the endoscopic surgery system has been described as an example here, the technique according to the present disclosure may also be applied to, for example, a microscopic surgery system, and the like.

### (Example of Practical Application to Mobile Body)

The technique according to the present disclosure is applicable to various products. For example, the technique according to the present disclosure may be achieved in the form of an apparatus to be mounted to a mobile body of any kind. Non-limiting examples of the mobile body may include an automobile, an electric vehicle, a hybrid electric vehicle, a motorcycle, a bicycle, a personal mobility device, an airplane, a drone, a vessel, a robot, a construction machine, and an agricultural machine (tractor).

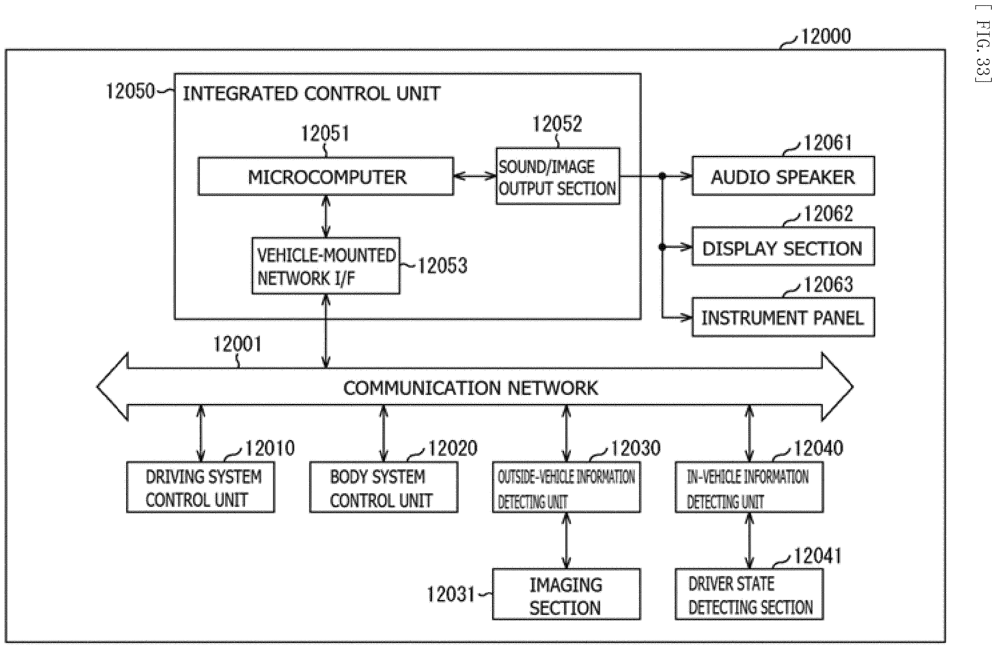

FIG. 33 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 33, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 33, an audio speaker 12061, a display section 12062, and an instrument panel 12063 are illustrated as the output device. The display section 12062 may, for example, include at least one of an on-board display and a head-up display.

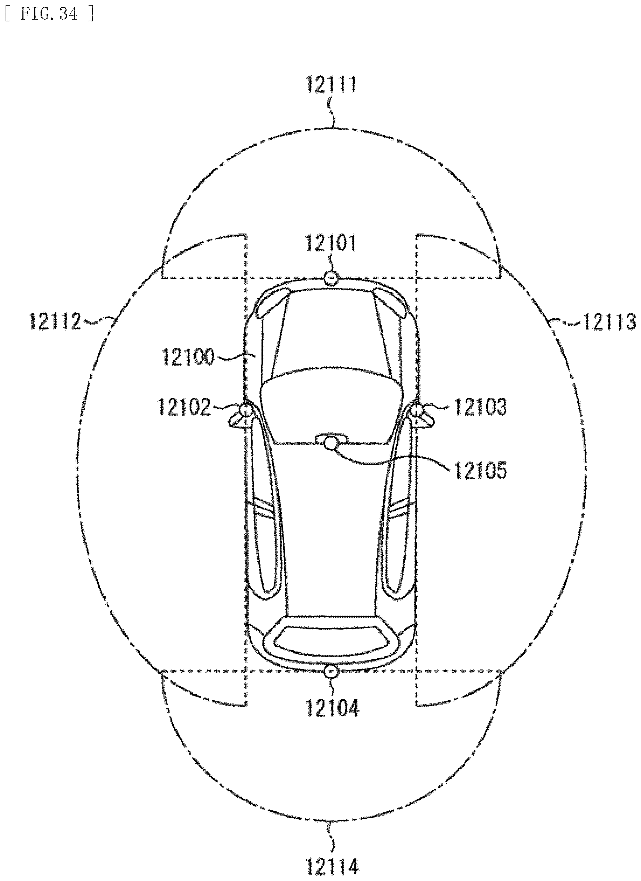

FIG. 34 is a diagram depicting an example of the installation position of the imaging section 12031.

In FIG. 34, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 34 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The description has been given above of an example of the mobile body control system, to which the technique of the present disclosure is applicable. The technique of the present disclosure is applicable to the imaging section 12031 among components of the configuration described above. Specifically, the imaging element (e.g., the imaging element 10) according to any of the foregoing embodiments and modification examples thereof is applicable to the imaging section 12031. The application of the technique according to the present disclosure to the imaging section 12031 allows for a high-definition captured image with less noise, thus making it possible to perform highly accurate control utilizing the captured image in the mobile body control system.

Although the first and second embodiments, Modification Examples 1 to 6, the application examples, and the practical application examples have been described above, the contents of the present disclosure are not limited to the above-described embodiments and the like, and various modifications are possible. For example, in the first embodiment, the imaging element includes the photoelectric converter 20 that detects the green light and the photoelectric conversion regions 32B and 32R that respectively detect the blue light and the red light. The photoelectric converter 20 and the photoelectric conversion regions 32B and 32R are stacked on one another. However, the contents of the present disclosure are not limited to such a configuration. For example, the red light or the blue light may be detected in the photoelectric converter, or the green light may be detected in the photoelectric conversion region.

Further, the number and the ratio of the photoelectric converter and the photoelectric conversion regions are not limited, and two or more photoelectric converters may be provided, or color signals of a plurality of colors may be obtained only by the photoelectric converter.

Further, in the above-described embodiments and the like, two electrodes including the readout electrode 21A and the accumulation electrode 21B are illustrated as the plurality of electrodes constituting the lower electrode 21. However, in addition to this, three or more electrodes such as a transfer electrode and a discharge electrode may be provided.

It is to be noted that the effects described in the present specification are merely examples and are not limitative, and other effects may be achieved.

It is to be noted that the present technology may have the following configuration. According to the present technology having the following configuration, it is possible to reduce the defects of the oxide semiconductor layer without hindering the transport of the carriers from the photoelectric conversion layer, making it possible to improve the imaging quality.
(1) A photoelectric conversion element including:
   a first electrode and a second electrode disposed side by side;
   a third electrode disposed to oppose the first electrode and the second electrode;
   a photoelectric conversion layer provided between the first electrode and the second electrode and the third electrode;
   an oxide semiconductor layer provided between the first electrode and the second electrode and the photoelectric conversion layer; and
   a protective layer provided between the photoelectric conversion layer and the oxide semiconductor layer, the protective layer including a first layer and a second layer, the first layer and the second layer including oxygen (O), an element X, and an element Y as a common element, the first layer and the second layer being stacked in this order from a side of the oxide semiconductor layer, in which
   the first layer and the second layer satisfy Rₓ₁ > Rₓ₂ ≥ 0 and 0 ≤ R_{y1} < R_{y2} in a case where a composition ratio of the element X and the element Y is defined as number of atoms of each of the element X and the element Y divided by total number of atoms of the element X and the element Y, and where the composition ratio of the element X included in the first layer is referred to as Rₓ₁, the composition ratio of the element Y included in the first layer is referred to as R_{y1}, the composition ratio of the element X included in the second layer is referred to as Rₓ₂, and the composition ratio of the element Y included in the second layer is referred to as R_{y2}.
(2) The photoelectric conversion element according to (1), in which Eco ≤ Ec_{B} <_ Ecc is satisfied in a case where an energy level at a lowermost end of a conduction band of the photoelectric conversion layer is referred to as Eco, an energy level at a lowermost end of a conduction band of the oxide semiconductor layer is referred to as Ecc, and an energy level at a lowermost end of a conduction band of the second layer is referred to as Ec_{B}.
(3) The photoelectric conversion element according to (1) or (2), in which a difference between the composition ratio Rₓ₁ of the element X in the first layer and the composition ratio Rₓ₂ of the element X in the second layer is 0.1 or more.
(4) The photoelectric conversion element according to any one of (1) to (3), in which the first layer has a film density smaller than a film density of the second layer.
(5) The photoelectric conversion element according to any one of (1) to (4), in which the first layer has a film thickness of 1 atomic layer or more and 5 nm or less, and the second layer has a film thickness of 1 nm or more and 10 nm or less.
(6) The photoelectric conversion element according to (5), in which a total film thickness of the first layer and the second layer is less than 10 nm.
(7) The photoelectric conversion element according to any one of (1) to (6), in which the first layer has a film density of 3.0 g/cm³ or less, and the second layer has a film density of 2.5 g/cm³ or more.
(8) The photoelectric conversion element according to any one of (1) to (7), in which the protective layer further includes a third layer having an opening at a position opposed to the first electrode.
(9) The photoelectric conversion element according to (8), in which Ec_{D} < Eco is satisfied in a case where the energy level at the lowermost end of the conduction band of the photoelectric conversion layer is referred to as Eco, and an energy level at a lowermost end of a conduction band of the third layer is referred to as Ec_{D}.
(10) The photoelectric conversion element according to (8) or (9), in which the protective layer has a film thickness of 1 nm or more and less than 10 nm at a position of the opening.
(11) The photoelectric conversion element according to (10), in which the protective layer has a film thickness of 1 nm or more and less than 100 nm at a position other than the opening.
(12) The photoelectric conversion element according to any one of (8) to (11), in which an area of the opening is larger than half of an area of the first electrode.
(13) The photoelectric conversion element according to any one of (1) to (12), in which the oxide semiconductor layer includes at least one kind of element out of indium, gallium, silicon, zinc, aluminum, and tin.
(14) The photoelectric conversion element according to any one of (1) to (13), in which the oxide semiconductor layer includes IGZO, Ga₂O₃, GZO, IZO, ITO, InGaAlO, or InGaSiO.
(15) The photoelectric conversion element according to any one of (1) to (14), in which the protective layer includes at least one kind of element out of tantalum, titanium, vanadium, niobium, tungsten, zirconium, hafnium, scandium, yttrium, lanthanum, gallium, and magnesium.
(16) The photoelectric conversion element according to any one of (1) to (15), in which a voltage is applied to each of the first electrode and the second electrode individually.
(17) A photoelectric conversion element including:
   a first electrode and a second electrode disposed side by side;
   a third electrode disposed to oppose the first electrode and the second electrode;
   a photoelectric conversion layer provided between the first electrode and the second electrode and the third electrode;
   an oxide semiconductor layer provided between the first electrode and the second electrode and the photoelectric conversion layer; and
   a protective layer provided between the photoelectric conversion layer and the oxide semiconductor layer, the protective layer including a plurality of layers, at least one of the plurality of layers having an opening at a position opposed to the first electrode.
(18) A photodetector including a plurality of pixels each provided with one or more photoelectric conversion elements, in which
   the photoelectric conversion elements each include
   a first electrode and a second electrode disposed side by side,
   a third electrode disposed to oppose the first electrode and the second electrode,
   a photoelectric conversion layer provided between the first electrode and the second electrode and the third electrode,
   an oxide semiconductor layer provided between the first electrode and the second electrode and the photoelectric conversion layer, and
   a protective layer provided between the photoelectric conversion layer and the oxide semiconductor layer, the protective layer including a first layer and a second layer, the first layer and the second layer including oxygen (O), an element X, and an element Y as a common element, the first layer and the second layer being stacked in this order from a side of the oxide semiconductor layer, and
   the first layer and the second layer satisfy Rₓ₁ > Rₓ₂ ≥ 0 and 0 ≤ R_{y1} < R_{y2} in a case where a composition ratio of the element X and the element Y is defined as number of atoms of each of the element X and the element Y divided by total number of atoms of the element X and the element Y, and where the composition ratio of the element X included in the first layer is referred to as Rₓ₁, the composition ratio of the element Y included in the first layer is referred to as R_{y1}, the composition ratio of the element X included in the second layer is referred to as Rₓ₂, and the composition ratio of the element Y included in the second layer is referred to as R_{y2}.

The present application claims the benefit of Japanese Priority Patent Application JP2022-020877 filed with the Japan Patent Office on February 14, 2022, the entire contents of which are incorporated herein by reference.

It should be understood by those skilled in the art that various modifications, combinations, sub-combinations and alterations may occur depending on design requirements and other factors insofar as they are within the scope of the appended claims or the equivalents thereof.

## Claims

1. A photoelectric conversion element comprising:
a first electrode and a second electrode disposed side by side;
a third electrode disposed to oppose the first electrode and the second electrode;
a photoelectric conversion layer provided between the first electrode and the second electrode and the third electrode;
an oxide semiconductor layer provided between the first electrode and the second electrode and the photoelectric conversion layer; and
a protective layer provided between the photoelectric conversion layer and the oxide semiconductor layer, the protective layer including a first layer and a second layer, the first layer and the second layer including oxygen (O), an element X, and an element Y as a common element, the first layer and the second layer being stacked in this order from a side of the oxide semiconductor layer, wherein
the first layer and the second layer satisfy Rₓ₁ > Rₓ₂ ≥ 0 and 0 ≤ R_{y1} < R_{y2} in a case where a composition ratio of the element X and the element Y is defined as number of atoms of each of the element X and the element Y divided by total number of atoms of the element X and the element Y, and where the composition ratio of the element X included in the first layer is referred to as Rₓ₁, the composition ratio of the element Y included in the first layer is referred to as R_{y1}, the composition ratio of the element X included in the second layer is referred to as Rₓ₂, and the composition ratio of the element Y included in the second layer is referred to as R_{y2}.

2. The photoelectric conversion element according to claim 1, wherein Ec_{O} ≤ Ec_{B} ≤ Ec_{C} is satisfied in a case where an energy level at a lowermost end of a conduction band of the photoelectric conversion layer is referred to as Eco, an energy level at a lowermost end of a conduction band of the oxide semiconductor layer is referred to as Ecc, and an energy level at a lowermost end of a conduction band of the second layer is referred to as Ec_{B}.

3. The photoelectric conversion element according to claim 1, wherein a difference between the composition ratio Rₓ₁ of the element X in the first layer and the composition ratio Rₓ₂ of the element X in the second layer is 0.1 or more.

4. The photoelectric conversion element according to claim 1, wherein the first layer has a film density smaller than a film density of the second layer.

5. The photoelectric conversion element according to claim 1, wherein the first layer has a film thickness of 1 atomic layer or more and 5 nm or less, and the second layer has a film thickness of 1 nm or more and 10 nm or less.

6. The photoelectric conversion element according to claim 5, wherein a total film thickness of the first layer and the second layer is less than 10 nm.

7. The photoelectric conversion element according to claim 1, wherein the first layer has a film density of 3.0 g/cm³ or less, and the second layer has a film density of 2.5 g/cm³ or more.

8. The photoelectric conversion element according to claim 1, wherein the protective layer further includes a third layer having an opening at a position opposed to the first electrode.

9. The photoelectric conversion element according to claim 8, wherein Ec_{D} < Eco is satisfied in a case where an energy level at a lowermost end of a conduction band of the photoelectric conversion layer is referred to as Eco, and an energy level at a lowermost end of a conduction band of the third layer is referred to as Ec_{D}.

10. The photoelectric conversion element according to claim 8, wherein the protective layer has a film thickness of 1 nm or more and less than 10 nm at a position of the opening.

11. The photoelectric conversion element according to claim 10, wherein the protective layer has a film thickness of 1 nm or more and less than 100 nm at a position other than the opening.

12. The photoelectric conversion element according to claim 8, wherein an area of the opening is larger than half of an area of the first electrode.

13. The photoelectric conversion element according to claim 1, wherein the oxide semiconductor layer includes at least one kind of element out of indium, gallium, silicon, zinc, aluminum, and tin.

14. The photoelectric conversion element according to claim 1, wherein the oxide semiconductor layer includes IGZO, Ga₂O₃, GZO, IZO, ITO, InGaAlO, or InGaSiO.

15. The photoelectric conversion element according to claim 1, wherein the protective layer includes at least one kind of element out of tantalum, titanium, vanadium, niobium, tungsten, zirconium, hafnium, scandium, yttrium, lanthanum, gallium, and magnesium.

16. The photoelectric conversion element according to claim 1, wherein a voltage is applied to each of the first electrode and the second electrode individually.

17. A photoelectric conversion element comprising:
a first electrode and a second electrode disposed side by side;
a third electrode disposed to oppose the first electrode and the second electrode;
a photoelectric conversion layer provided between the first electrode and the second electrode and the third electrode;
an oxide semiconductor layer provided between the first electrode and the second electrode and the photoelectric conversion layer; and
a protective layer provided between the photoelectric conversion layer and the oxide semiconductor layer, the protective layer including a plurality of layers, at least one of the plurality of layers having an opening at a position opposed to the first electrode.

18. A photodetector comprising a plurality of pixels each provided with one or more photoelectric conversion elements, wherein
the photoelectric conversion elements each include
a first electrode and a second electrode disposed side by side,
a third electrode disposed to oppose the first electrode and the second electrode,
a photoelectric conversion layer provided between the first electrode and the second electrode and the third electrode,
an oxide semiconductor layer provided between the first electrode and the second electrode and the photoelectric conversion layer, and
a protective layer provided between the photoelectric conversion layer and the oxide semiconductor layer, the protective layer including a first layer and a second layer, the first layer and the second layer including oxygen (O), an element X, and an element Y as a common element, the first layer and the second layer being stacked in this order from a side of the oxide semiconductor layer, and
the first layer and the second layer satisfy Rₓ₁ > Rₓ₂ ≥ 0 and 0 ≤ R_{y1} < R_{y2} in a case where a composition ratio of the element X and the element Y is defined as number of atoms of each of the element X and the element Y divided by total number of atoms of the element X and the element Y, and where the composition ratio of the element X included in the first layer is referred to as Rₓ₁, the composition ratio of the element Y included in the first layer is referred to as R_{y1}, the composition ratio of the element X included in the second layer is referred to as Rₓ₂, and the composition ratio of the element Y included in the second layer is referred to as R_{y2}.
